# EUROPEAN PATENT APPLICATION

(11) **EP 1 715 386 A1**
(43) Date of publication of application: **25.10.2006**
(21) Application number: 06008301.1
(22) Date of filing: 21.04.2006
(51) Int. Cl.: G03F 7/32, B41C 1/10

(54) **Replenisher for photosensitive planographic printing plate and plate making method using the same**

(30) Priority: 21.04.2005 JP 2005124323; 27.09.2005 JP 2005280813
(71) Applicant: Fuji Photo Film Co., Ltd., Minami-Ashigara-shi, Kanagawa (JP)
(72) Inventor: Koizumi, Shigeo, Yoshida-cho Haibara-gun Shizuoka-ken (JP); Yamamoto, Hisao, Yoshida-cho Haibara-gun Shizuoka-ken (JP); Nagase, Hiroyuki, Yoshida-cho Haibara-gun Shizuoka-ken (JP)
(74) Representative: HOFFMANN EITLE

(57) **Abstract**

The invention provides a replenisher used for developing a precursor of a negative working photosensitive planographic plate using a developer comprising an alkali metal hydroxide and a surfactant but no silicate compounds, and having a pH of 10.5 to 12.5, wherein the replenisher is an aqueous solution comprising a chelating agent having ability for forming a water-soluble chelating compound with an aluminum ion, an alkali metal hydroxide and a surfactant but no silicate compounds, and having a pH of 11 to 13.5.

## Description

### BACKGROUND OF THE INVENTION

### FIELD OF THE INVENTION

The invention relates to a replenisher for a photosensitive planographic printing plate and a plate making method using the same. In particular, the invention relates to a replenisher favorably used for plate making of a negative working photosensitive planographic plate capable of direct plate making and a plate making method for a negative working planographic printing plate, wherein the negative working printing plate (printing plate of a negative type) can be directly prepared by scanning a laser based on a digital signal from a computer.

### DESCRIPTION OF THE RELATED ART

Laser technology has developed remarkably in recent years, and high output and compact-sized laser sources having an emission range from visible to infrared have become readily available. These laser sources are quite useful as recording light sources for directly making a printing plate using digital data from a computer (Computer to Plate; abbreviated as CTP hereinafter). For example, solid lasers and semiconductor lasers emitting light at a wavelength of 760 nm to 1200 nm are useful since laser sources in this wavelength range have a higher output power than those of other wavelength ranges. Accordingly, photosensitive image-forming materials and direct plate making systems using such a wavelength range have become keenly desired in recent years.

An image-forming material taking advantage of a radical addition polymerization reaction has been proposed for such image-forming materials, wherein an image is usually formed by development with an aqueous alkali solution after image-wise exposure with laser light. In the proposed methods, the image is either subjected to a heating treatment after exposure followed by developing the image or is developed immediately after exposure without applying any heat treatment. The former method has drawbacks of the requirement for large size equipment and high cost, since a heating oven needs to be provided in an automatic development machine. On the other hand, the drawback of the latter is that hardening of the exposed portion is rather slow since radical polymerization is not sufficiently accelerated by exposure, resulting in lower printing durability than the heating method. However, the non-heating method is advantageous for users since no heating oven is required, and hence is desired.

It is desirable, in order to sufficiently improve printing durability in the non-heating method, to reduce the damage of the image portion as much as possible during the development process. Examples of conventional plate making methods are disclosed where, for example, a negative type photosensitive planographic plate using a thermal polymerizing recording layer is developed using a strongly alkaline aqueous solution (with a pH exceeding 12.5) containing potassium silicate or the like (see, for example Japanese Patent Application Laid-Open (JP-A) No. 08-108621). The developer at such a high pH level causes considerable damage to the imaging portion, resulting in insufficient printing durability of the planographic printing plate. Since silicates are readily gelled in a developer containing alkali metal silicates at a pH of 11.5 or lower, and it is feared that such developer unstable, it was difficult in practice to use a developer with a pH of 12 or lower, which causes less damage to the imaging portion. In addition, large amounts of components of the planographic printing plate having acidic groups get dissolved in the developer, to resulting in a lowered pH level, or the pH of the developer may be also lowered by repeated use since carbon dioxide in the air gets dissolved into the developer. Therefore, these problems have been solved by increasing the initial pH of the developer by taking such phenomena into consideration. For example, the pH often decreases to 11.5 or lower with time due to the factors as described above, even when the initial pH is about 12, and as stated above, lowering of the pH makes the developer unstable, and gels containing silicate salts accumulate in the development layer to cause problems of clogging of connection pipes and contamination (soiling) of feed rollers.

For solving these problems, a developer containing no silicates, or a so-called non-silicate developer at a pH of 12.5 or lower has been proposed as a developer that is suitable for the negative type photosensitive planographic plates and that causes less damage to the imaging portion. A large difference in the solubility between exposed portions and non-exposed portions (discrimination) is required for the development property of the developer, in order to allow a stable function as the planographic printing plate to be exhibited using a low pH developer containing no silicates and being excellent in hydrophilizing property. Improvements of the developer as described above by adding a specific surfactant to the developer are disclosed, (see, for example, JP-ANos. 10-239858 and 2002-91016.

Another method disclosed is to develop a layer of a photosensitive resin composition formed on the surface of a glass substrate with a mixed aqueous solution of, for example, sodium carbonate and sodium hydrogen carbonate at a pH of about 10 (see, for example, JP-A Nos. 2002-91016 and 11-65126). However, the developability at non-imaging portions has not always been satisfactory when such a developer is applied to a photosensitive planographic printing plate having a photosensitive layer of the photopolymerizable photosensitive resin composition on the surface of an aluminum support.

It is known that the aluminum support is dissolved by the alkali into the developer as aluminum ions when a planographic printing plate precursor comprising a negative type recording layer on the surface of aluminum having a hydrophilic surface is treated with a developer containing no silicates at a pH of about 12.5. For preventing aluminum from being dissolved, providing a layer comprising an organic metal compound, or a sol-gel reaction solution obtained by hydrolysis and condensation polymerization of an inorganic metal compound, a polymer compound and a plasticizer, on the back surface opposite to the photopolymerization layer of the aluminum substrate is disclosed (see, for example, JP-A No. 8-240914).

While dissolution of aluminum from the back surface of the aluminum support may be prevented by providing an aluminum dissolution-prevention layer as described above, aluminum at the non-imaging portions at the printing plate surface side could not be prevented from being dissolved by this method. The pH of the developer attached to the surface of the roller of the printing plate feed rollers in the developer bath, being exposed to the air is lowered, due to the carbon dioxide in the air, and when the aluminum ion concentration in the developer increases, white stains mainly comprising aluminum hydroxide adhere onto the roller. In particular, when such stains adhere onto the surface of a squeezing roller at the exit of the developer bath, drawability of the developer decreases, and a large amount of the developer remaining attached to the surface of the printing plate is transferred to a rinsing step following the development treatment. Crystals of aluminum hydroxide precipitate when the pH of the developer decreases by being diluted with water, and accumulate in the rinsing bath. Consequently, it was known that problems of clogging of the connection pipes and spray nozzles are caused by continuously processing a large amount of the printing plates for a long period of time.

### SUMMARY OF THE INVENTION

The invention has been made in view of the above circumstances, and provides a replenisher for photosensitive planographic printing plates and a plate making method using the same.

A first aspect of the present invention provides a development process using an alkaline developer having a relatively low pH, a replenisher containing no silicate compounds, with a specific pH, and containing a chelating compound and a specific surfactant, and have thereby completed the invention.
A second aspect of the present invention provides a replenisher for a negative type photosensitive planographic plate, comprising an aqueous solution of a chelating agent, capable of forming a water-soluble chelate compound with aluminum ions, a hydroxide of an alkali metal and a surfactant, wherein the aqueous solution contains no silicate compounds and has a pH of 11 to 13.5.
The replenisher of a planographic printing plate of a negative type as described above may be favorably used for making a plate through the processes comprising (i) exposing image-wise a planographic printing plate precursor comprising a negative type recording layer on an aluminum support, and (ii) developing the image using a developer containing no silicate salt compounds, the developer containing a hydroxide of an alkali metal and a surfactant and having a pH of 10.5 to 12.5, and the replenisher.

While the function of the invention is not clear, it may be presumed as follows:
While the replenisher of the invention contains a chelating compound as typified by hydroxycarboxylic acids, the compound exists as an alkali salt in the developer when the pH is 11 or higher, but the compound functions as a chelating agent for aluminum ions when the pH decreases to 10.5 or lower, and the chelating compound is believed to prevent aluminum hydroxide from precipitating by forming a water-soluble complex. When the pH of the water bath decreases as a result of mixing into the rinsing bath developer attached to the surface of the printing plate that contains a large amount of aluminum ions, no precipitates of aluminum hydroxide are formed due to containing hydroxycarboxylic acids capable of forming a complex with aluminum ions in the developer. Consequently, it is possible to significantly reduce the amount of the precipitates of aluminum hydroxide accumulated in the rinsing bath, and printing plates may be stably processed for a long period of time.

The plate making method according to an aspect of the of the invention comprises (i) exposing an image on a precursor of the photosensitive planographic printing plate including a negative working recording layer on an aluminum support having a hydrophilic surface, (ii) developing the precursor of the planographic printing plate after the exposure using a developer containing no silicate compounds, the developer including a hydroxide compound of an alkali metal and a surfactant, and having a pH of 10.5 to 12.5, and a replenisher (iii) rinsing the planographic printing plate after development with water, wherein the replenisher used in the developing (ii) does not contain silicate compounds and is an aqueous solution comprising: a chelating agent, having the ability to form a water-soluble chelate compound with aluminum ions; a hydroxide of an alkali metal and a surfactant; and has a pH of 11 to 13.5.

### DETAILED DESCRIPTION OF THE INVENTION

### [Developer and Replenisher]

The developer and replenisher used for the plate making method of the invention will be described first. The developer of the invention is a developer for a photosensitive planographic printing plate containing an alkali metal hydroxide, an anionic surfactant, preferably a specific anionic surfactant in the range of 1.0% by mass to 10% by mass, and having a pH of 10.5 to 12.5.
While the developer used in the invention can be used by diluting a solution having the same composition as the replenisher of the invention to be described in detail hereinafter with water, the pH of the diluted solution is preferably adjusted to be about 1 pH unit lower than the pH of the replenishing solution, or to a pH of 10.5 to 12.5. More preferably, the ionic concentration and pH of the diluted solution is adjusted to be optimal. The developer is not always required to contain a chelating agent for forming a water-soluble chelate compound with aluminum ions.

The replenisher of the invention is a developer for the photosensitive planographic printing plate containing a chelating agent that forms a water-soluble chelate compound with aluminum ions under a weakly alkaline atmosphere at least in the range of pH of 7.0 to 10.5 (referred to as a specific chelate compound hereinafter as appropriate), an alkali metal hydroxide and an anionic surfactant, preferably a specific surfactant to be described hereinafter, in the range of 1.0% by mass to 10% by mass, and having a pH of 11 to 13.5. The developer is poured into a developer bath at the start of development in a fully automatic development system. The replenisher is preferably replenished as the amount of developing throughput increases.

### [1] Chelating agent that forms the water-soluble chelate compound with aluminum ions:

The replenisher of the invention contains a specific chelating compound that forms a water-soluble chelate compound with the aluminum ion under a weakly alkaline atmosphere at the pH of 7.0 to 10.5. Consequently, the aluminum ion is masked when the pH in the developer bath decreases with time, or when the pH decreases by dilution as a result of transferring the developer into a rinsing bath, and crystals of aluminum hydroxide is effectively prevented from precipitation.

Any chelating agent may be used as the specific chelating compound in the invention, so long as it is a chelating agent capable of stably forming a water-soluble chelate compound in a wide pH range of neutral pH to weakly alkaline pH.
Examples of such chelating agent include aminopolycarboxylic acids such as EDTA and NTA, and partial salts thereof; hydroxycarboxylic acids such as tartaric acid and citric acid, and partial salts thereof; monoamino dicarboxylic acids such as glutamic acid and aspartic acid, and partial salts thereof; and aliphatic polycarboxylic acids such as oxalic acid, malonic acid, succinic acid and maleic acid, and partial salts thereof. Of these chelating agents, the hydroxycarboxylic acids and partial salts thereof (referred to hydroxycarboxylic acids hereinafter) may be preferably used from the viewpoint of their high safety and high solubility. Safety for handling the hydroxycarboxylic acids have been already confirmed, since the hydroxycarboxylic acids are produced in vivo and have been frequently used for pharmaceutical agents, nutrient supplements and food additives. Hydroxycarboxylic acids have a higher solubility than aminopolycarboxylic acids having the same function.

Specific examples of the hydroxycarboxylic acids include citric acid, malic acid, isocitric acid, tartaric acid, lactic acid and glycolic acid, and partial alkali metal salts such as sodium and potassium partial salts, and ammonium partial salts. Citric acid and malic acid, and partial alkali metal salts thereof are preferable among them, because water-soluble aluminum chelate compounds of these acids are stable in a wide pH range, and these acids are highly safe in the human body and are highly soluble in water. The partial salt as used herein refers to a salt of a part or all of the carboxylic groups involved in the chelating agent. The number of chelation (the proportion of the carboxylic group forming a salt) refers to an average number of each compound, and is not necessarily restricted to an integer.

While the amount of the hydroxycarboxylic acids added for such purposes is determined according to the amount of replenishment of the replenisher and the processing ability of the plate making system, it is preferably added to the replenisher in the range of 15 mmol/L to 200 mmol/L, more preferably from 20 mmol/L to 100 mmol/L, and most preferably from 30 mmol/L to 80 mmol/L.
Since the hydroxycarboxylic acids are added as a sequestering agent, a system that increases the concentration of the hydroxycarboxylic acids in the developer bath with the increase of the concentration of the dissolved aluminum ion as a result of an increase of development is advantageous from the economical point of view and from the viewpoint of environmental protection against waste solutions. A preferable method of addition is to permit the hydroxycarboxylic acids to be contained only in the replenisher that is added in accordance with development. Accordingly, the specific chelating compound is not necessarily contained in the developer as described above.

### [2] Anionic surfactant

The anionic surfactant used in the developer and replenisher of the invention are preferably selected from at least one of the surfactants selected from the group of the compounds represented by the following formulae (1-A) and (1-B).
Both the developer for the photosensitive planographic printing plate and replenisher for the photosensitive planographic printing plate are used in the preferable aspects of the invention, wherein the developer contains at least one of the anionic surfactants selected from the group consisting of the anionic surfactants represented by formulae (1-A) and (1-B) in the range of 1.0% by mass to 10% by mass and having a pH of 10 to 12.5, and the replenisher contains the specific surfactant in the range of 1.0% by mass to 10% by mass and having a pH of 11 to 13.5.

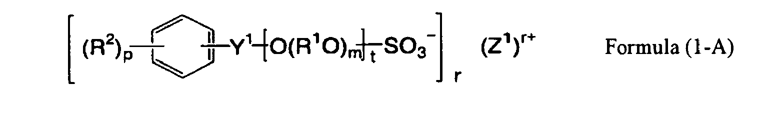

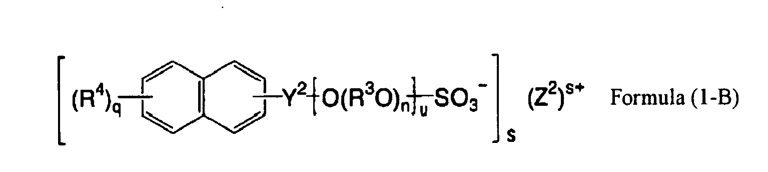

In the formulae (1-A) and (1-B), R¹ and R³ each independently represents a linear or branched alkylene group having 1 to 5 carbon atoms, and R² and R⁴ each independently represents a linear or branched alkylene group having 1 to 20 carbon atoms. r and s each independently represents an integer of 0, 1 or 2.Y¹ and Y² each independently represents a single bond or an alkylene group having 1 to 10 carbon atoms, n and m each independently represents an integer of 1 to 100. Plural R¹ and R³ may be the same or different from each other when n or m are 2 or more. t and u each independently represents 0 or 1. Z¹ and Z² each independently represent an alkali metal ion, an alkali earth metal ion or a non-substituted ammonium ion or an ammonium ion substituted with an alkyl group. p and q each independently represents an integer selected from 0 to 2.

Preferable examples of R¹ and R³ in the preferable aspect of the invention include -CH₂-, -CH₂CH₂- and - CH₂CH₂CH₂-, more preferably -CH₂CH₂-. Preferable examples of R² and R⁴ are CH₃, C₂H₅, C₃H₇, C₄H₉. r and s are preferably 0 or 1. Y¹ and Y² each is preferably a single bond. n and m each is preferably an integer of 1 to 20.
Specific examples of the compound represented by formula (1-A) or (1-B) is as follows:

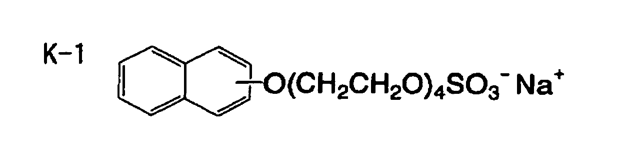

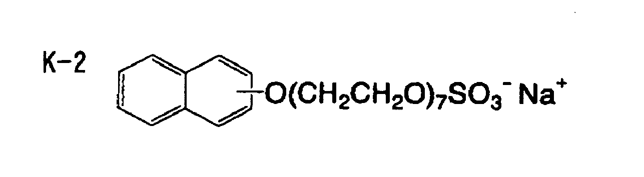

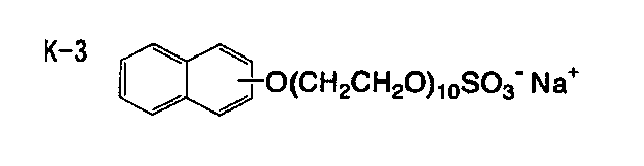

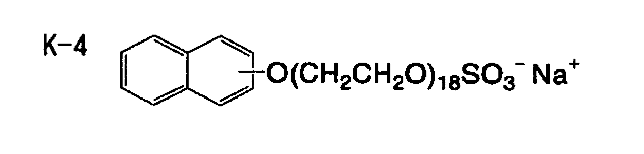

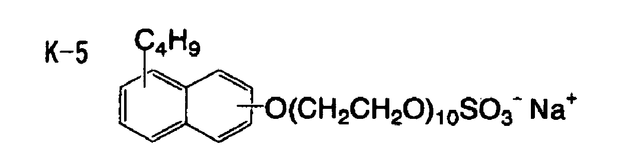

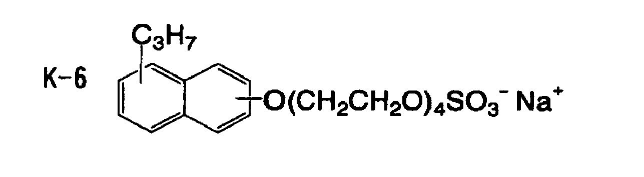

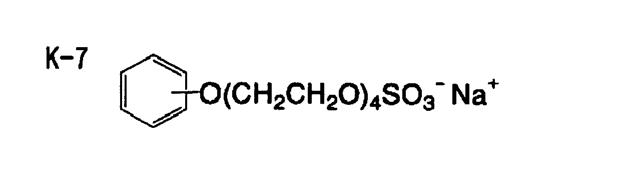

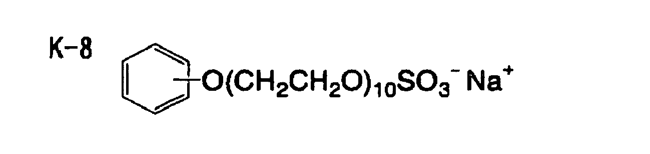

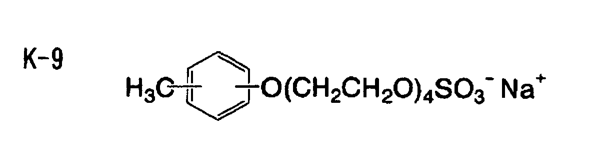

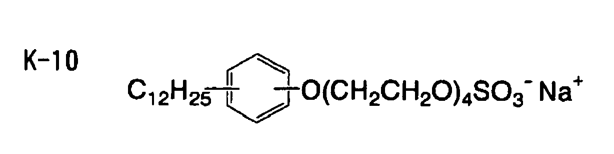

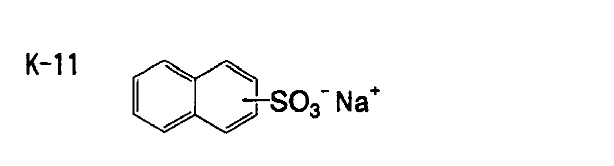

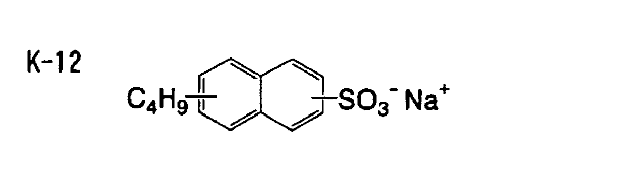

The effective amount of addition of the specific surfactant in the developer and replenisher is appropriately from 1.0 to 10% by mass, preferably from 2.0 to 10% by mass.
A too small amount of addition of the surfactant causes a decrease in development property and a decrease in solubility of the components in the photosensitive negative type recording layer, while too much amount deteriorates printing durability of the printing plate.

Surfactants other than those described above may be added to the replenisher of the invention, and to the developer to be used together. Examples of the surfactant available for the invention include nonionic surfactants including polyoxyethylene alkyl ethers such as polyoxyethylene naphthyl ether, polyoxyethylene alkylphenyl ether, polyoxyethylene lauryl ether, polyoxyethylene cetyl ether and polyoxyethylene stearyl ether; polyoxyethylene alkyl esters such as polyoxyethylene stearate; sorbitan alkyl esters such as sorbitan monolaurate, sorbitan monostearate, sorbitan distearate, sorbitan monooleate, sorbitan sesquioleate and sorbitan trioleate; and monoglyceride alkyl esters such as glycerol monostearate and glycerol monooleate.
These surfactants may be used alone, or a as a combination thereof. The content of these surfactants in the developer and replenisher is preferably from 0.1 to 10% by mass as converted into the amount of effective ingredients.

Chelating agents for divalent metal may be added to the replenisher of the invention in order to suppress compounds contained in the developer and water used for preparing the developer and replenisher, or used for rinsing from precipitating. Examples of the divalent metal include magnesium and calcium. Examples of the chelating agent include polyphosphates such as Na₂P₂O₇, Na₅P₃O₃, Na₃P₃O₉, Na₂O₄P(NaO₃P)PO₃Na₂ and calgon(sodium polymetaphoaphate); ethylenediamine tetraacetic acid, potassium salt thereof and sodium salt thereof; diethylenetriamine pentaacetic acid, potassium salts thereof and sodium salt thereof; triethylenetetramine hexaacetic acid, potassium salt thereof and sodium salt thereof; hydroxyethyl ethylenediamine triacetic acid, potassium salt thereof and sodium salt thereof; nitrilotriacetic acid, potassium salt thereof and sodium salt thereof; aminopolycarboxylic acids such as
1,2-diaminocyclohexane tetraacetic acid, potassium salt thereof and sodium salt thereof, and 1,3-diamino-2-propanol tetraacetic acid, potassium salt thereof and sodium salt thereof; as well as organic phosphonic acids such as 2-phosphonobutane tricarboxylic acid-1,2,4, potassium salt thereof and sodium slat thereof; 2-phosphonobutane tricarboxylic acid-2,3,4, potassium salt thereof and sodium slat thereof; 1-phosphonoethane tricarboxylic acid-1,2,2, potassium salt thereof and sodium slat thereof; 1-hydroxyethane-1,1-diphosphonic acid, potassium salt thereof and sodium slat thereof; and aminotri(methylene phosphonic acid), potassium salt thereof and sodium slat thereof.
While an optimum amount of use of the chelating agent changes according to the hardness of water used and the amount of use of water, the chelating agent is usually contained in the developer and replenisher of use in the range of 0.01 to 5% by mass, preferably from 0.01 to 0.5% by mass.

Since the developer and replenisher tend to foam by adding the anionic surfactant, an antifoam agent may be added to the developer and replenisher. The amount of the antifoam agent added to the developer and replenisher is preferably about 0.00001% by mass or more, more preferably from about 0.0001 to about 0.5% by mass.
A fluorine-base or silicone-base antifoam agent and an antifoam agent containing acetylenealcohol and/or acetyleneglycol may be added to the replenisher and concomitantly used developer of the invention.

Examples of the fluorine-base antifoam agent include those represented by the formula below, or polyoxyethylene alkyl ether, polyoxyethylene alkylaryl ether and polyoxyethylene polyoxypropylene ether.

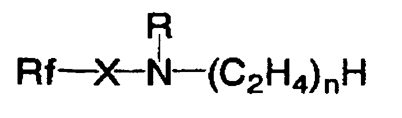

In the formula, R represents H or an alkyl group, Rf represents a fluorocarbon group in which all or a part ofH is substituted with F preferably a fluorocarbon group having about 5 to about 10 carbon atoms, X represents CO or SO₂, and n represents an integer in the range of about 1 to about 10.
A nonionic surfactant with HLB in the range of 1 to 9, particularly a nonionic surfactant with HLB in the range of 1 to 4 is preferably used as the antifoam agent as described above. The surfactant is directly added to, or added as an emulsion mixed with water or another solvent to the replenisher and developer to be used together.

Examples of the silicone-base antifoam agent include dialkyl polydioxane, preferably dimethyl polydioxane represented by the following formula, which is used directly or as an O/W type emulsion thereof;

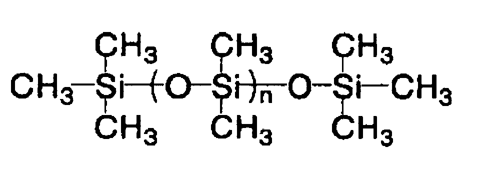

(n: an integer of 20 to 10,000)

alkoxypoly (ethyleneoxy)siloxane represented by the formulae below;

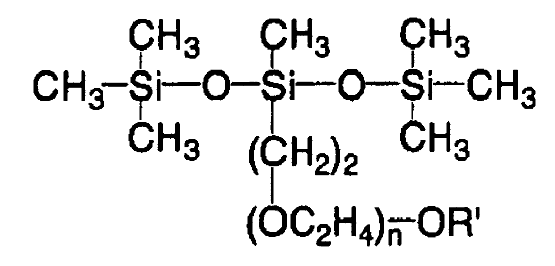

(n: an integer of 6 to 10, R': a lower alkyl group C₁ to C₄); 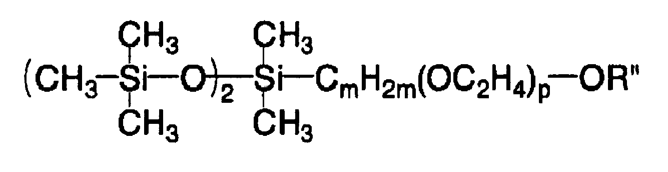 (m: an integer of 2 to 4, p: an integer of 4 to 12, R": a lower alkyl group C₁ to C₄)

Modified dimethyl polydioxane prepared by partially introducing carboxylic acid groups or sulfonic acid groups, or an emulsion of these silicone compounds prepared by mixing with water and a conventionally used anionic surfactant, is also used.

Acetylene alcohol refers to an unsaturated alcohol having an acetylene bond (triple bond) in the molecule. Acetylene glycol also refers to alkin diol, which is an unsaturated glycol having an acetylene bond (triple bond) in the molecule.
More specifically, the compound is represented by the following formulae (I) and (II):

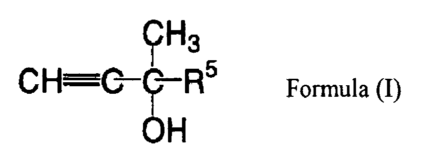

where, in formula(I), R⁵ represents liner or branched alkyl group having 1 to 5 carbon atoms; and

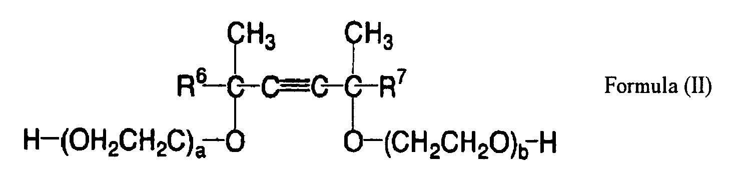

where, in formula (II), R⁶ and R⁷ each independently represents a liner or branched alkyl group having 1 to 5 carbon atoms, and a+b represents an integer of 0 to 30.
In the formula above, examples of the linear or branched alkyl group having 1 to 5 carbon atoms include methyl, ethyl, isopropyl, isobutyl and isopentyl groups.

More specific examples of acetylene alcohol and acetylene glycol are as follows:

(1) propargyl alcohol

   CH≡C-CH₂OH
(2) propargyl carbinol

   **CH≡C-CH**_{**2**}**-CH**_{**2**}**OH**
(3) 3,5-dimethyl-1-hexine-3-ol 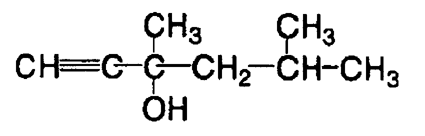
(4) 3-methyl-1-butine-3-ol 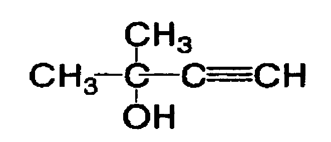
(5) 3-methyl-1-pentine-3-ol 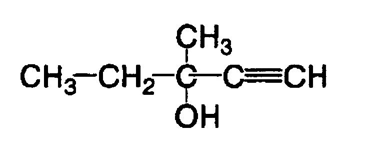
(6) 1,4-butine diol

   HO-CH₂-C≡C-CH₂-OH
(7) 2,5-dimethyl-3-hexine-2,5-diol

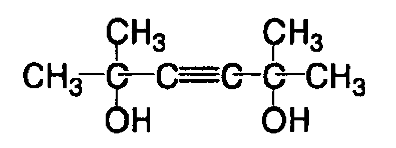

(8) 3,6-dimethyl-4-octine-3,6-diol 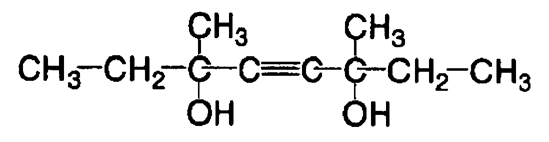
(9) 2,4,7,9-tetramethyl-5-decine-4,7-diol 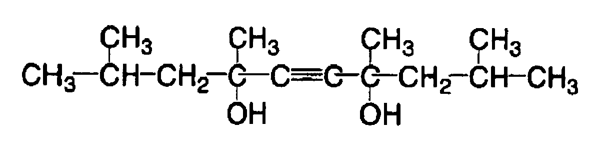
(10) ethyleneoxide adduct of 2,4,7,9-tetramethyl-5-decine-4,7-diol 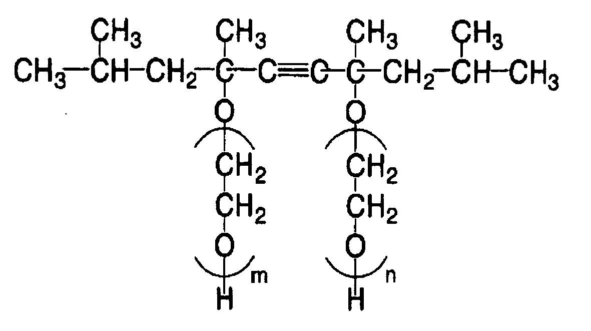 (m + n = 1 to 30)
(11) 2,5,8,11-tetramethyl-6-dodecine-5,8-diol

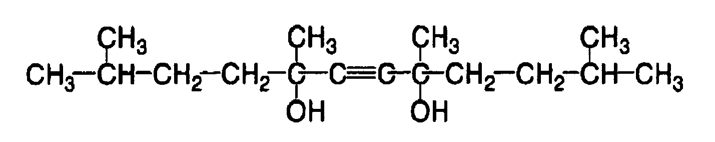

These acetylene alcohols and acetylene glycols are commercially available, and examples thereof include SURFYNOL™ (Air Products and Chemicals Inc.).
Typical examples of the commercially available products include SURFYNOL 61 (an example of compound (3) described above), OLFINE B (an example of compound (4) described above), OLFINE P (an example of compound (5) described above), OLFINE Y (an example of compound (7) described above), SURFYNOL 82 (an example of compound (8) described above), SURFYNOL 104 and OLFINE AK-02 (examples of compound (9) described above), SURFYNOL 400 series (an example of compound (10) described above), and SURFYNOL DF-110 (an example of compound (11) described above).

Alkali metal salts of organic acids and alkali metal salts of inorganic acids may be added to the replenisher of the invention and developer used together as development adjusting agents. For example sodium, potassium or ammonium carbonate, or sodium, potassium or ammonium citrate may be added, alone or as a combination thereof, to the replenisher and the developer.

Examples of the alkali agent contained in the developer favorably used in the invention include inorganic alkali agents such as sodium tertiary phosphate, potassium tertiary phosphate, ammonium tertiary phosphate, sodium borate, potassium borate, ammonium borate, sodium hydroxide, potassium hydroxide, ammonium hydroxide, and lithium hydroxide; and organic alkali agents such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethyleneimine, ethylenediamine, pyridine, and tetramethylammonium hydroxide. In the invention, one of these alkali agents may be used or two or more of them can be used together.

The replenisher of the invention and the developer used in the invention may further contain the following components in addition to the components described above, if necessary. Examples thereof include organic carboxylic acids such as benzoic acid, phthalic acid, p-ethylbenzoic acid, p-n-propylbenzoic acid, p-iso-propylbenzoic acid, p-n-butylbenzoic acid, p-t-butylbenzoic acid, p-2-hydroxyethylbenzoic acid, decanoic acid, salicyclic acid, and 3-hydroxy-2-naphthoic acid; organic solvents such as iso-propyl alcohol, benzyl alcohol, ethyl cellosolve, butyl cellosolve, phenyl cellosolve, propylene glycol, and diacetone alcohol; and chelating agents, reducing agents, dyes, pigments, water softeners, and antiseptics.

A pH should essentially be of 10 to 12.5, preferably from 11 to 12.5. The electric conductivity x should be in the range of 2 < x < 30 mS/cm, preferably in the range of 5 to 25 mS/cm.

The electric conductivity can be adjusted by adding a conductivity-adjusting agent such as an alkali metal salt of an organic acid or an alkali metal salt of an inorganic acid .

The replenisher for the negative type photosensitive planographic plate according to the invention does not contain silicate compounds in the composition, as described above, and is an aqueous solution comprising: a chelating agent, having an ability to form a water-soluble chelate compound with aluminium ions, prefarably 5.0 mmol/L to 200mmol/L of an hydroxycarboxylic acid; a surfactant, prefarably 1.0 to 10% by mass of a specific surfactant; and having a pH in the range of 11 to 13.5, by adding a predetermined amount of the hydroxide of the above mentioned alkali metal as an alkali agent.
While the replenisher of the invention is favorable for use in the developing of a precursor of a planographic printing plate having a photopolymerizing or thermal polymerizing negative type photosensitive layer using the developer containing no silicate compounds and having a pH of 10.5 to 12.5, such a developer is an aqueous solution comprising an alkali metal hydroxide as a major component, containing a surfactant, preferably 1.0 to 10% by mass of the specific surfactant as described above, and having a pH of 10.5 to 12.5.

### [Method for making a precursor of a planographic printing plate]

The plate making method of the invention will be described below. A significant feature of the plate making method of the invention is to use the replenisher of the invention and the developer favorably used in the invention in the development step.
The plate making method of the invention comprises (i) an exposure process for image-wise exposing the precursor of a photosensitive planographic printing plate having a negative type recording layer comprising a compound for generating radicals by light or heat, a polymerizing compound and a radiation absorber on an aluminum support having a hydrophilic surface.

### (Exposure)

The image is exposed by a known method under a condition corresponding to characteristics of the photosensitive layer of the precursor of the planographic printing plate. The image is exposed at a wavelength corresponding to the spectral sensitivity of the photosensitive layer, and the method for exposing the image may be exposure by scanning or full range exposure through a mask.
The method suitable for respective precursors of the planographic printing plate to which the plate making method of the invention is applied will be described in detail, wherein the preferable planographic printing plates are thermal polymerizing photosensitive planographic printing plates or photopolymerizing photosensitive planographic printing plate.

Subsequent processes comprise (ii) developing the precursor of the planographic printing plate after exposure using a developer, that is a developer not containing silicate compounds, the developer containing an alkali metal hydroxide, a specific surfactant and having a pH of 10.5 to 12.5, and the replenisher, and (iii) rinsing the planographic printing plate after the development.
The replenisher of the developer used in the developing (ii) is the replenisher for the photosensitive planographic printing plate of the invention.

An automatic developing machine is preferably used in the plate-making method of the invention. The developing (ii) is performed by immersion development, spray development or brush development at a temperature from 20 to 40°C, preferably from 25 to 35°C. Since the developer wears out according to the amount of development when an automatic development machine is used, the development property is restored using the replenisher. The replenishment method is preferably used in the invention.

The printing plate is prepared through rinsing (iii) after the development treatment. The object of the rinsing is to wash out the developer after dissolving components of the photosensitive layer by the development treatment particularly from the surface of non-image portions and the developer in which other components are dissolved from the surface of the printing plate.
In the plate making method using an automatic development machine, rinsing water is repeatedly used while a certain amount of water is replenished according to the amount of development of the plate material. Aluminum ions dissolved in the developer, which are accumulated as the treatment proceeds, adhere onto the plate material and are transferred to the rinsing step. Then, aluminum hydroxide crystals precipitate during the rinsing step due to a decrease in pH by being diluted with rinsing water. However, the aluminum ions are masked in the plate making method of the invention by containing a chelating agent that forms a water-soluble chelate compound with the aluminum ion at the pH of 7.0 to 11.0 in the replenisher, and aluminum hydroxide crystals are prevented from being precipitated.

The replenisher and the plate making method of the invention are preferable since the effects thereof become evident by using them for the photosensitive planographic printing material to be described hereinafter. Example of preferable photosensitive compositions treated by the plate making method of the invention include a so-called "thermal polymerizing photosensitive composition" comprising an infrared absorber, a polymerization initiator, an ethylenically unsaturated bond-containing monomer and a binder polymer; and a so-called "photopolymerizing photosensitive composition" comprising a photopolymerization initiation system, a photopolymerizable composition and a binder polymer.
The photosensitive composition favorably used in the plate making method of the invention will be described below.

### [Photopolymerizing photosensitive composition]

The photopolymerizing photosensitive composition as an example of the photosensitive composition treated with the replenisher of the invention comprises a photopolymerization initiation system sensitive to a light at a wavelength from visible to ultraviolet regions, polymerizable compound having at least one ethylenically unsaturated bond, and a binder polymer.
Such a photosensitive composition can be used for a photosensitive planographic plate by providing a photosensitive layer (image recording layer) by coating the composition on a support such as an aluminum plate. The photosensitive planographic printing plate comprises a photosensitive layer and optionally a protective layer sequentially laminated on the support. The phrase "sequentially laminate" as used herein refers to providing an undercoat layer, a photosensitive layer and a protective layer in this order on the support. The undercoat layer and protective layer may be provided as necessary, and other layers provided according to the object of use (for example an intermediate layer and back-coat layer) are not necessarily omitted.

### [Photopolymerization initiation system sensitive to a light at a wavelength in the range of visible to ultraviolet regions]

The photopolymerization initiation system sensitive to a light at a wavelength in the range of visible to ultraviolet wavelength regions refers to a system capable of initiating photopolymerization by absorbing a light at a wavelength in the range of visible to ultraviolet wavelength regions. More specifically, the system comprises a combination of a sensitizing pigment having a maximum absorption wavelength in the range of visible to ultraviolet wavelength regions, preferably ranging from 330 to 700 nm, and a photopolymerization initiator. Two or more photopolymerization initiators may be used together (a combination system). Various sensitizing pigments (dyes) and photopolymerization initiators, or combined systems of two or more photopolymerization initiators, known in the art may be appropriately selected as the photopolymerization initiation system according to the wavelength of the light source to be used.

Even in the case that visible light with 400 nm or longer wavelength, Ar laser, secondary harmonics of semiconductor laser, or SHG-YAG laser is used as a light source, a variety of photo initiator systems have been proposed and examples includes systems of a variety of photoreductive dyes described in USP No. 2,850,445, e.g. Rose Bengale,Eosin, Erythrocin and the like or systems of combinations dyes and initiators, e.g. composite initiator systems of dyes and amines (JP-B No. 44-20189); combination systems of hexaaryl bisimidazole, radical generating agents, and dyes (JP-B No. 45-37377); systems of hexaaryl bisimidazole and p-dialkylaminobenzylidene ketones (JP-B No. 47-2528, JP-A No. 54-155292); systems of cyclic sis-α-dicarbonyl compounds and dyes (JP-ANo. 48-84183); systems of cyclic triazine and merocyanine dyes (JP-ANo. 54-151024); systems of 3-ketocumarin and activating agents (JP-ANos. 52-112681 and 58-15503); systems of bisimidazole, styrene derivatives, and tiols (JP-A No. 59-140203); systems of organic peroxides and coloring materials (JP-A Nos. 59-1504, 59-140203, 59-189340, and 62-174203, JP-B No. 62-1641, USP No. 4,766,055); systems of dyes and activated halides (JP-A Nos. 63-258903 and 2-63054); systems of dyes and borate compounds (JP-ANos. 62-143044, 62-150242, 64-13140, 64-13141, 64-13142, 64-13143, 64-13144, 64-17048, 1-229003, 1-298348, 1-138204 and the like); systems of coloring materials having rhodanine ring and radical generating agents (JP-A Nos. 2-179643 and 2-244050); systems of titanocenes and 3-ketocumarin coloring materials (JP-A No. 63-221110); systems of combinations of titanocenes, xanthene coloring materials, and ethylenically unsaturated compounds containing amino groups or urethane groups (JP-A Nos. 4-221958 and 4-219756); systems of titanocenes and specified merocyanine coloring materials (JP-A No. 6-295061), and systems of titanocene and benzopyran ring-containing coloring materials (JP-A No. 8-334897).

Recently, a laser (violet laser) with a wavelength of 400 to 410 nm, as well as photopolymerization initiation systems having a high sensitivity to a light with a wavelength of 450 nm or less have been developed and these system are also used. Examples of the system include a cationic dyes/borates systems (JP-A No. 11-84647), a merocyanine dyes/titanocenes systems (JP-ANo. 2000-147763) and carbazole type dyes/titanocenes systems (JP-A No. 2001-42524).

It is known that the photopolymerization property is further enhanced by adding a hydrogen donor compound such as thiol compounds including 2-mercaptobenzthiazole, 2-mercaptobenzimidazole and 2-mercaptobenzoxazole, and amine compounds including N-phenylglycine and N,N-dialkyl aminoaromatic alkyl ester. These photopolymerization initiation systems are used in the range of 0.05 to 100 parts by mass, preferably from 0.1 to 70 parts by mass, and further preferably from 0.2 to 50 parts by mass relative to 100 parts by mass of the ethylenically unsaturated compound described below.

### [Polymerizing compound having at least one ethylenically unsaturated group]

The polymerizing compound having at least one ethylenically unsaturated group (referred to an ethylenically unsaturated bond-containing compound hereinafter) is a compound having ethylenically unsaturated bonds that are cross-linked and cured by addition polymerization by the action of the photopolymerization initiator when the photosensitive composition is irradiated to an active light. The compound containing the ethylenically unsaturated bond capable of addition polymerization may be arbitrarily selected from compounds having at least one, preferably two or more of the ethylenically unsaturated bonds at the terminal. For example, the chemical form of the compound is a monomer or a prepolymer, or a dimer, a trimer and an oligomer or a mixture thereof, or a copolymer thereof.

Examples of the monomer and copolymer thereof include esters of unsaturated carboxylic acids (such as acrylic acid, methacrylic acid, itaconic acid, crotonic acid, isocrotonic acid and maleic acid) and aliphatic polyvalent alcohols, and amides of unsaturated carboxylic acids and aliphatic polyvalent amine compounds.
Examples of the monomers for the esters of an aliphatic polyvalent alcohol compound and an unsaturated carboxylic acid include acrylic esters such as ethylene glycol diacrylate, triethylene glycol diacrylate, 1,3-butanediol diacrylate, tetramethylene glycol diacrylate, propylene glycol diacrylate, neopentyl glycol diacrylate, trimethylol propane triacrylate, trimethylol propane tri(acrlyloyloxypropyl)ether, trimethylol ethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol haxaacrylate, sorbitol triacrylate, sorbitol tetraacrylate, sorbitol pentaacrylate, sorbitol haxaacrylate, tri(acrlyloyloxyethyl)isocyanurate, and polyester acrylate oligomers.

Examples of the methacrylic esters include tetramethylene glycol dimethacrylate, triethylene glycol dimethacrylate, neopentyl glycol dimethacrylate, trimethylol propane trimethacrylate, trimethylol ethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, dipentaerythritol pentamethacrylate, sorbitol trimethacrylate, sorbitol tetramethacrylate, bis
[p-(3-methacryloxy-2-hydroxypropoxy)phenyl] dimethyl methane, and bis-[p-(methacryloxyethoxy)phenyl] dimethyl methane.

Examples of the itaconic esters include ethylene glycol diitaconate, propylene glycol diitaconate, 1,5-butanediol diitaconate, 1,4-butanediol diitaconate, tetramethylene glycol diitaconate, pentaerythritol diitaconate, and sorbitol tetraitaconate.
Examples of the crotonic esters include ethylene glycol dicrotonate, tetramethylene glycol dicrotonate, pentaerythritol dicrotonate, and sorbitol tetradicrotonate.
Examples of the isocrotonic esters include ethylene glycol diisocrotonate, pentaerythritol diisocrotonate, and sorbitol tetraisocrotonate.

Examples of the maleic acid ester include ethyleneglycol dimaleate, triethyleneglycol dimaleate, pentaerythritol dimaleate and sorbitol tetramaleate. Mixtures of the ester monomers are also included in the example. Specific examples of the monomer of the aliphatic polyvalent amine compound and unsaturated carboxylic acid amide include methylenebis-acrylamide, methylenebis-methacrylamide, 1,6-hexamethylenebis-acrylamide, 1,6-hexamethylenebis-methacrylamide, diethylenetriamine trisacrylamide, xylylene bisacrylamide and xylylene bismethacrylamide.

Another example is a vinyl urethane compound having two or more polymerizable vinyl groups in a molecule prepared by adding a vinyl monomer having a hydroxyl group represented by formula (A) below to a polyisocyanate compound having two or more isocyanate groups in a molecule described in JP-B No. 48-41708.

CH₂ = C(R¹)COOCH₂CH(R²)OH (A)

wherein R¹ and R² represent H or CH₃.

Other examples include polyfunctional acrylates and methacrylates such as urethane acrylates described in JP-A No. 51-37193 and JP-B No. 2-32293; polyester acrylates described in JP-ANo. 48-64183, and JP-B Nos. 49-43191 and 52-30490; and epoxy acrylates prepared by allowing epoxy resins to react with (meta)acrylic acid.

### [Binder polymer]

Organic polymers soluble or swellable in an aqueous alkaline solution is used for the binder polymer (polymer binding material) in the photosensitive layer of the photopolymerizing polymer, since the binder is required not only to serve as a film-forming material in the photosensitive layer, but also to be able to dissolve in the alkaline developer.
Examples of such organic polymers include addition polymers having carboxylic acid groups at the side chain, for example those disclosed in JP-A No. 59-44615, and JP-B Nos. 54-34327, 58-12577 and 54-25957, and JP-A Nos. 54-92723, 59-53836and 59-71048, or methacrylic acid copolymers, acrylic acid copolymers, itaconic acid copolymers, crotonic acid copolymers, maleic acid copolymers and partially esterified maleic acid copolymers.

Other examples are acidic cellulose derivatives having carboxylic acid groups at the side chain. Compounds having cyclic acid anhydrides added to addition polymers having hydroxyl groups are also useful. Copolymers of [benzyl(meta)acrylate/(meta)acrylic acid /other addition polymerizable vinyl monomers, if necessary], and copolymers of [allyl(meta)acrylate (meta)acrylic acid/other addition polymerizable vinyl monomers, if necessary] are particularly favorable. Other useful water-soluble organic polymers are polyvinyl pyrrolidone and polyethylene oxide. Alcohol-soluble polyamide and polyethers of 2,2-bis-(4-hydroxyphenyl)-propane and epichlorohydrin are useful for increasing the strength of cured films.

Polyurethane resins described in JP-B Nos. 7-120040, 7-120041, 7-120042 and 8-12424, and JP-ANos. 63-287944, 63-287947, 1-271741 and 11-352691 are useful for the uses of the invention.

The strength of the cured film of these polymers may be improved by introducing radical-reactive groups to the side chain. Examples of addition-polymerizable functional groups include an ethylenically unsaturated bond group, amino group and epoxy group; and examples of functional groups capable of forming a radical by light irradiation include a mercapto group, thiol group, halogen atom, triazine structure and onium salt structure. While ethylenically unsaturated bond groups such as acrylic group, methacrylic group, allyl group and styryl group are particularly preferable as the functional groups capable of the addition polymerization reaction, functional groups selected from amino group, hydroxyl group, phosphonic acid group, phosphoric acid group, carbamoyl group, isocyanate group, ureide group, ureylene group, sulfonic acid group and ammonio group are also useful.

An appropriate molecular weight and acid value of the binder polymer are preferable for maintaining development property of the photosensitive layer, and a polymer with a weight average molecular weight ranging from 5,000 to 300,000, and an acid value in the range of 20 to 200 is effectively used.
While an arbitrary amount of the binder polymer may be mixed to the total composition of the photosensitive layer, the proportion is preferably 10 to 90% by mass, preferably 30 to 80% by mass. A proportion of 90% by mass or less is preferable for giving a preferable result in the endurance of the image formed. The mass ratio between the compound containing photopolymerizable ethylenically unsaturated bonds and the binder polymer is preferably in the range of 1/9 to 9/1, more preferably from 2/8 to 8/2, and further preferably from 3/7 to 7/3.

### [Other components]

A small amount of a heat polymerization inhibitor is desirably added to the photosensitive layer in addition to the basic components above in order to prevent the polymerizable ethylenically unsaturated compound from unnecessarily polymerizing by heat during the production process or storage of the photosensitive composition.
A coloring agent may be added for coloring the photosensitive layer. Examples of the coloring agent include pigments such as phthalocyanine pigments (such as C. I. Pigment Blue 15:3, 15:4 and 15:6), azo pigments, carbon black and titanium oxide; and dyes such as ethyl violet, crystal violet, azo dyes, anthraquinone dyes and cyanin dyes.

### [Exposure step of photopolymerizing photosensitive planographic printing plate]

Light sources suitable for the exposure step of the photopolymerizing photosensitive planographic printing plate in the plate making method of the invention are a visible light with a wavelength of 400 nm or more, an Ar laser, a second harmonics of semiconductor laser, a SHG-YAG laser and a violet laser. Espetially, the image is preferably exposed to the violet semiconductor laser at a wavelength of 400 to 410 nm. The output of the laser is preferably 30 mW or more, and an internal drum or a multi-beam laser device having a short exposure time is preferably used. Curing of the photosensitive layer cannot be sufficiently advanced when the exposure energy is too low, while fogging may be generated due to halation light to possibly cause deterioration of the image quality when the exposure energy is too high. Accordingly, an exposure condition suitable for characteristics of the recording layer is preferably selected.

### [Thermal polymerizing photosensitive composition]

The thermal polymerizing photosensitive composition will be described hereinafter. The thermal polymerizing photosensitive composition usually comprises an infrared absorber, a polymerization initiator, an ethylenically unsaturated bond-containing monomer and a binder polymer.

### (Infrared absorber)

The infrared absorber has a function for converting absorbed infrared light into heat. The polymerization initiator (radical generator) to be described below is decomposed by the heat generated to form radicals. The infrared absorber used in the invention is preferably a dye or pigment having a maximum absorption at a wavelength in the range of 760 nm to 1200 nm.

Commercially available dyes and known dyes described in literature, for example, in "Dye Handbook" (edited by Socity of Synthetic Organic Chemistry and published in 1970) may be used as the dye. Typical examples thereof include azo dyes, metal complex salt azo dyes, pyrazolone azo dyes, naphthoquinone dyes, anthraquinone dyes, phthalocyanine dyes, carbonium dyes, quinonimine dyes, methine dyes, cyanine dyes, squalelium dyes, pyrylium salts, and metal thiolate complexes.

The dye is preferably a cyanine dye described in JP-ANos. 58-125246, 59-84356, 59-202829 or 60-78787; a methine dye described in JP-ANos. 58-173696, 58-181690, or 58-194595; a naphthoquinone dye described in JP-A Nos. 58-112793, 58-224793, 59-48187, 59-73996, 60-52940, or 60-63744; a squalelium dye described in JP-A No. 58-112792; and/or a cyanine dye described in U.K. Patent No. 434,875.

The near infrared ray-absorbing sensitizers described in US Patent No. 5,156,938 are also preferably used. Also preferably used are the substituted aryl benzo(thio) pyrylium salts described in US Patent No. 3,881,924; the trimethine thiapyrylium salts described in JP-A No. 57-142645 (US Patent No. 4,327,169); the pyrylium type compounds described in JP-ANos. 58-181051, 58-220143, 59-41363, 59-84248, 59-84249, 59-146063, and 59-146061; the cyanine dyes described in JP-A No. 59-216146; the pentamethine thiopyrylium salts described in US Patent No. 4,283,475; and the pyrylium compounds described in JP-B Nos. 5-13514 and 5-19702. Other preferable examples of the dyes include the near infrared ray-absorbing dyes of the general formulae (I) and (II) described in US Patent No. 4,756,993.

Other preferable examples of the infrared absorbing dye in the present invention include specific indolenine cyanine dyes described in Japanese Patent Application Nos. 2001-6326 and 2001-237840, as shown below.

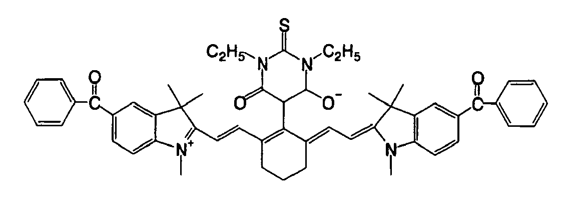

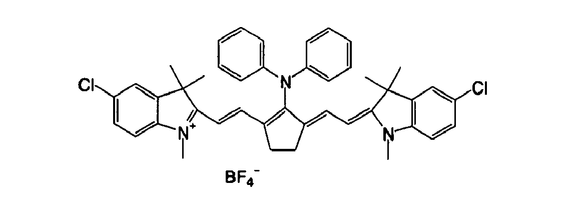

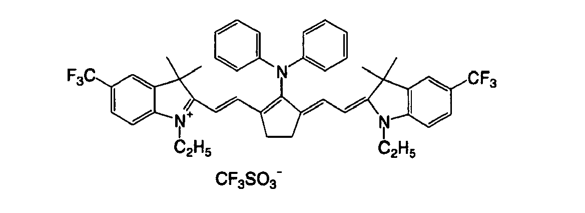

Particularly preferable among these dyes are cyanine dyes, squarylium dyes, pyrylium salts, nickelthiolate complexes and indolenine cyanine dyes. The dyes are more preferably cyanine dyes and indolenine cyanine dyes, still more preferably cyanine dyes represented by the general formula (a).

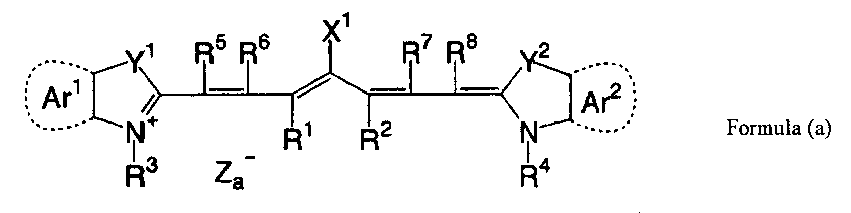

In the formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having 1 to 12 carbon atoms, an aromatic ring having a heteroatom, and a hydrocarbon group having 1 to 12 carbon atoms containing a heteroatom. The heteroatom refers to N, S, O, halogen atom or Se.

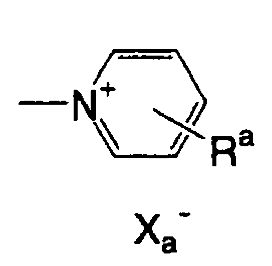

Xa has the same meaning as that of Za⁻ defined later, and R^{a} represents a substituent group selected from a hydrogen atom, an alkyl group, an aryl group, a substituted or unsubstituted amino group, and a halogen atom. R¹ and R² independently represent a hydrocarbon group having 1 to 12 carbon atoms. For the purpose of storability of the coating solution of the recording layer, each of R¹ and R² is preferably a hydrocarbon group having 2 or more carbon atoms, and more preferably R¹ and R² are linked to each other to form a 5- or 6-memberred ring.

Ar¹ and Ar² may be the same or different and each represents an aromatic hydrocarbon group which may have a substituent group. The aromatic hydrocarbon group is preferably a benzene ring or a naphthalene ring. The substituent group is preferably a hydrocarbon group having 12 or less carbon atoms, a halogen atom or an alkoxy group having 12 or less carbon atoms. Y¹ and Y² may be the same or different and each represents a sulfur atom or a dialkyl methylene group having 12 or less carbon atoms. R³ and R⁴ may be the same or different and each represents a hydrocarbon group having 20 or less carbon atoms, which may have a substituent group. The substituent group is preferably an alkoxy group having 12 or less carbon atoms, a carboxyl group or a sulfo group. R⁵, R⁶, R⁷ and R⁸ may be the same or different and each represents a hydrogen atom or a hydrocarbon group having 12 or less carbon atoms. Each of R⁵, R⁶, R⁷ and R⁸ is preferably a hydrogen atom because the starting material is easily available. Za⁻ represents a counter anion. However, when the cyanine dye represented by the general formula (a) has an anionic substituent group in its structure and does not necessitate neutralization of the charge, Za⁻ is not necessary. For the purpose of storability of the coating solution of the recording layer, Za⁻ is preferably a halogen ion, a perchlorate ion, a tetrafluoroborate ion, a hexafluorophosphate ion or a sulfonate ion, particularly preferably a perchlorate ion, a hexafluorophosphate ion or an aryl sulfonate ion.

While the infrared absorbing agent may be added to the same layer in which other components are added, or may be added to another layer separately provided, when the thermal polymerizing photosensitive composition is applied to the photosensitive planographic printing plate. However, when the negative type photosensitive planographic printing plate is made, the infrared absorbing agent is added so that the absorbance of the photosensitive layer at a maximum absorption wavelength in the range of 760 nm to 1200 nm falls within a range of 0.5 to 1.2 as measured by a reflection method. The absorbance is preferably in the range of 0.6 to 1.15. The content of the infrared absorbing agent is preferably in the range of 0.1 to 10% by mass, more preferably from 0.5 to 5.0% by mass, in the photosensitive composition as converted into a solid content.

### (Polymerization initiator)

As the polymerization initiator for initiation and promotion of the curing reaction of the polymerizable compound, a sulfonium salt polymerization initiator which is a thermally decomposed radical generating agent to be decomposed by heat to generate radicals is preferably contained in the thermal polymerizing photosensitive composition of the present invention.
In the present invention, the sulfonium salt polymerization initiator is used preferably in combination with the infrared absorber described above to generate radicals by the heat converted from infrared rays absorbed by the infrared ray absorber upon irradiation with an infrared laser. Such combination is preferable in the invention since highly sensitive heat mode recording is possible by this combination.

Examples of the sulfonium salt polymerization initiator suitable for use in the invention include an onium salt represented by the following Formula (1).

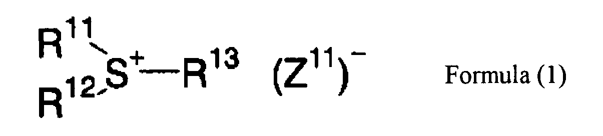

In Formula (1), R¹¹, R¹² and R¹³ may be the same as or different from each other, and each represent a hydrocarbon group having 20 or less carbon atoms which may have one or more substituents. Typical examples of the substituent(s) include halogen atoms, a nitro group, alkyl groups having 12 or less carbon atoms, alkoxy groups having 12 or less carbon atoms, and aryloxy groups having 12 or less carbon atoms. (Z¹¹)⁻ represents a counter ion selected from the group consisting of a halogen ion, a perchlorate ion, a tetrafluoroborate ion, a hexafluoro phosphate ion, a carboxyate ion, and a sulfonate ion, and is preferably a perchlorate ion, a hexafluorophosphate ion, a carboxyate ion, or an arylsulfonate ion.

Hereinafter, examples of the onium salts ([OS-1] to [OS-10]) represented by the general formula (1) are mentioned, but the onium salts are not limited thereto.

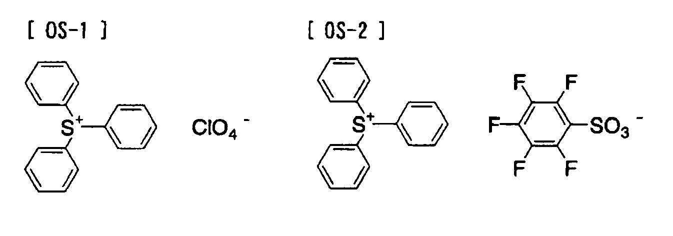

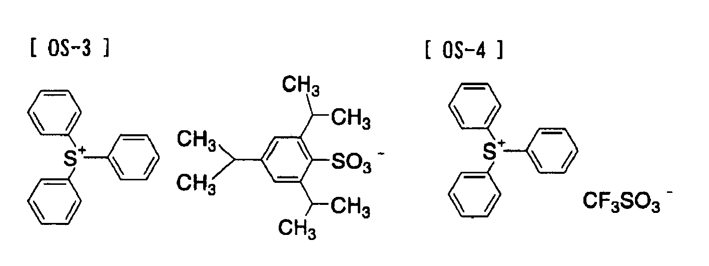

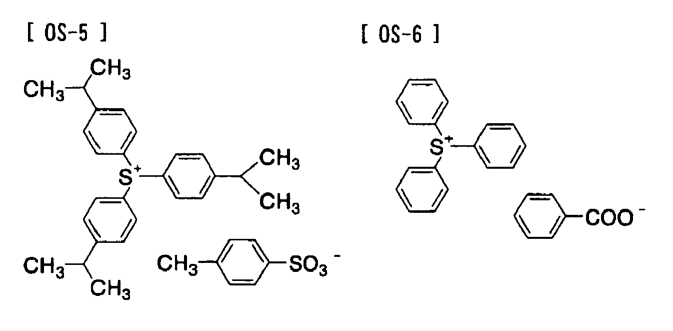

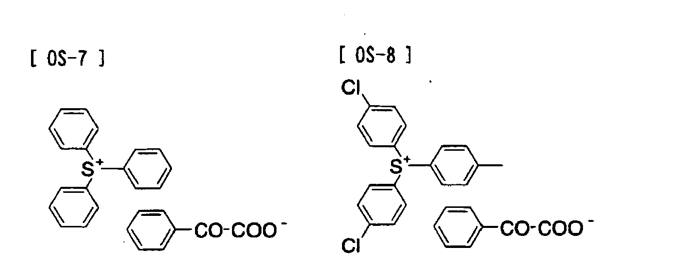

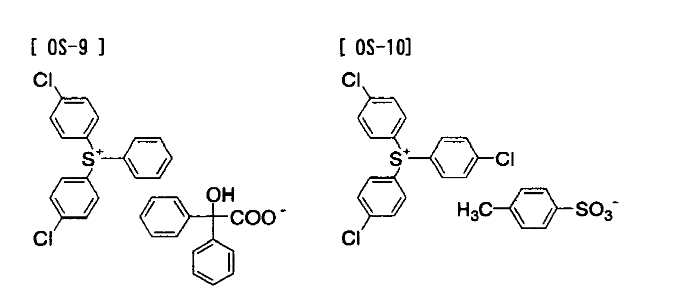

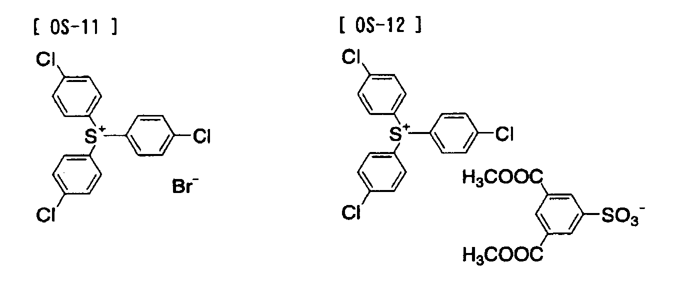

In addition to the compounds described above, a specific aromatic sulfonium salt described in JP-ANos. 2002-148790, 2002-148790, 2002-350207, and 2002-6482 may also be preferably used.

In the present invention, other polymerization initiators (other radical generating agents) can be used in combination with the sulfonium salt polymerization initiator. The other radical generating agents include onium salts (excluding sulfonium salts), triazine compounds having a trihalomethyl group, peroxides, azo-type polymerization initiators, azide compounds, quinone diazide, oxime ester compounds and triaryl monoalkyl borate compounds. Among these compounds, the onium salts are highly sensitive and preferably used.

Other onium salt suitable for use in the invention can be an iodonium salt and a diazonium salt. In the invention, the onium salt does not function as an acid generator but functions as an initiator for radical polymerization.
Specific examples of other onium salt for use in the invention include onium salts represented by the following Formulae (2) and (3).

Ar²¹―I⁺―Ar²² (Z²¹)⁻ Formula (2)

Ar³¹―N⁺≡N (Z³¹)⁻ Formula (3)

In Formula (2), Ar²¹ and Ar²² each independently represent an aryl group having 20 or less carbon atoms which may have one or more substituents. If the aryl group is substituted, typical examples of the substituent(s) include halogen atoms, a nitro group, alkyl groups having 12 or less carbon atoms, alkoxy groups having 12 or less carbon atoms, and aryloxy groups having 12 or less carbon atoms. (Z²¹)⁻ represents a counter ion having the same meaning as that of (Z¹¹)⁻.

In Formula (3), Ar³¹ represents an aryl group having 20 or less carbon atoms which may have one or more substituents. Typical examples of the substituent(s) include halogen atoms, a nitro group, alkyl groups having 12 or less carbon atoms, alkoxy groups having 12 or less carbon atoms, aryloxy groups having 12 or less carbon atoms, alkylamino groups having 12 or less carbon atoms, dialkylamino groups having 12 or less carbon atoms, arylamino groups having 12 or less carbon atoms, and diarylamino groups having 12 or less carbon atoms. (Z³¹)⁻ represents a counter ion having the same meaning as that of (Z¹¹)⁻.

Hereinafter, typical examples of the onium salt represented by Formula (2) ([OI-1] to [OI-10]), and the onium salt represented by Formula (3) ([ON-1] to [ON-5]) suitable for use in the invention are shown below, but the invention is not limited by them.

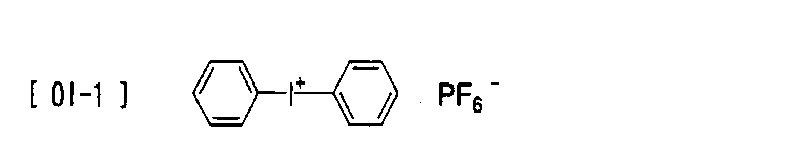

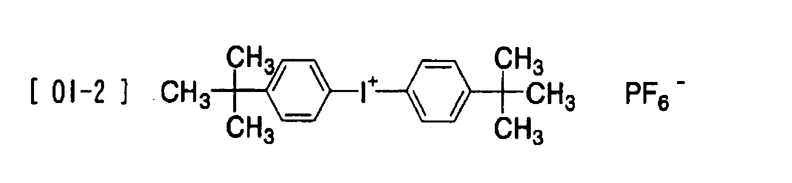

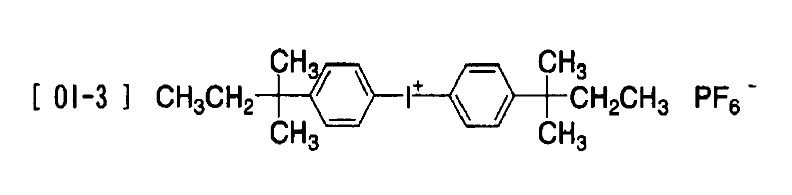

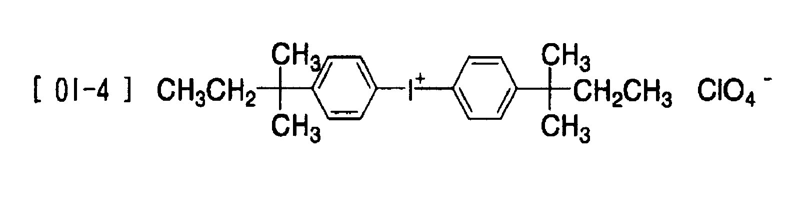

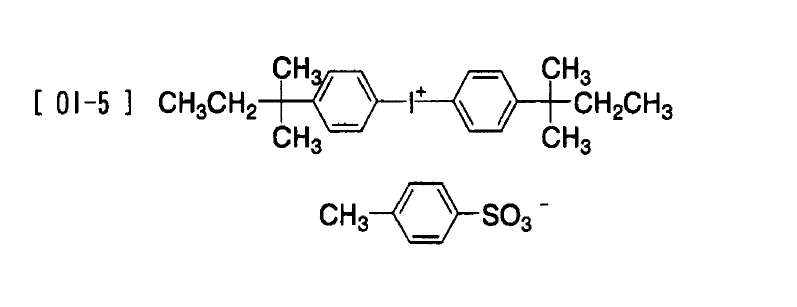

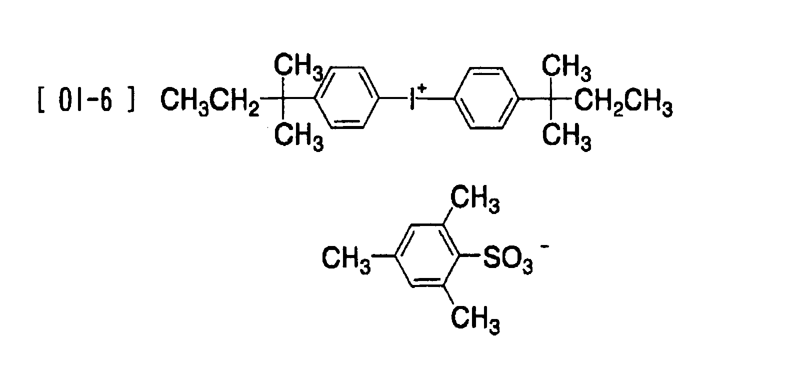

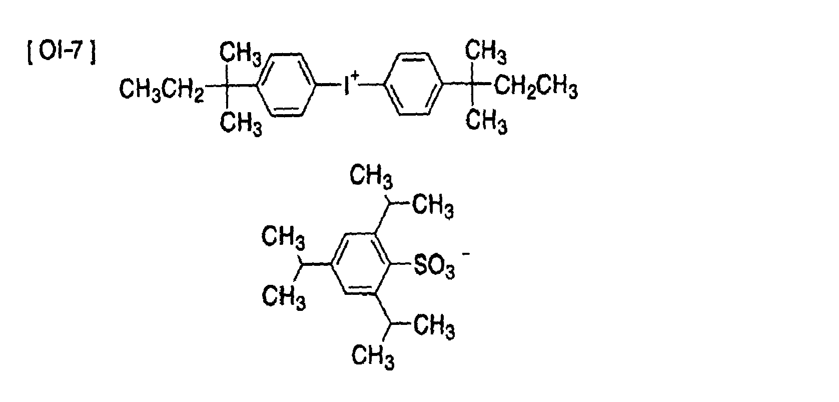

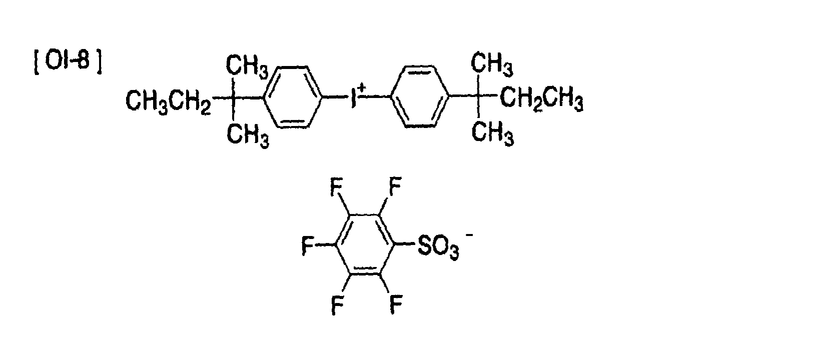

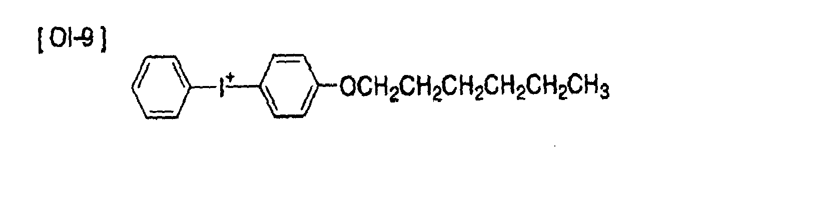

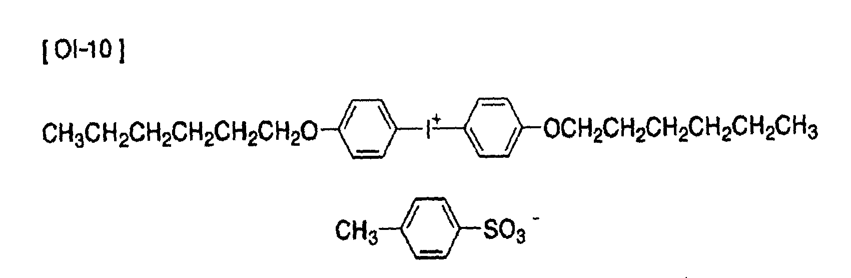

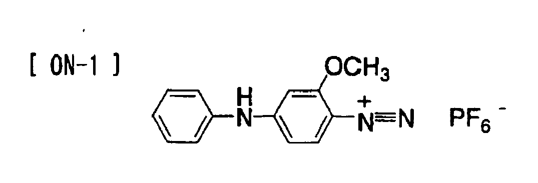

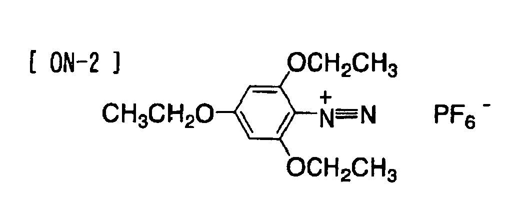

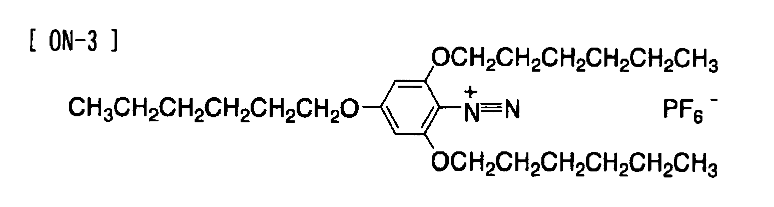

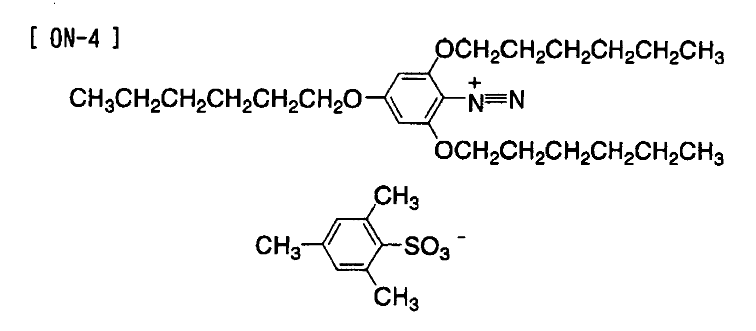

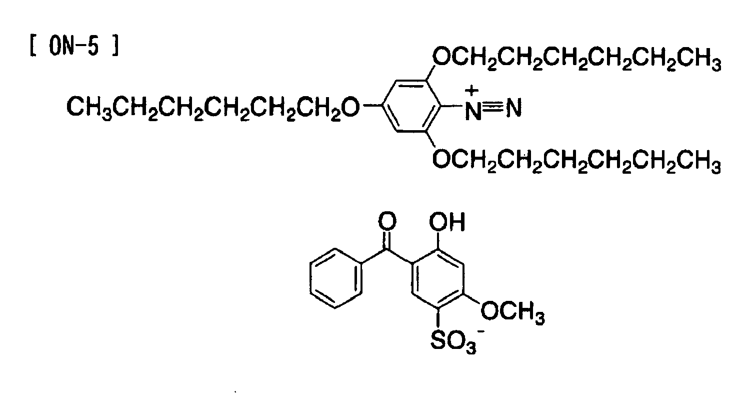

Typical examples of the onium salt suitable for use in the invention as the polymerization initiator (radical generator) include those described in JP-ANo. 2001-133696.

The polymerization initiator (radical generator) used in the invention preferably has a maximum absorption wavelength of 400 nm or less and more preferably 360 nm or less. When the polymerization initiator has an absorption wavelength in the ultraviolet region, it becomes possible to handle the planographic printing plate under white light.

The total content of the polymerization initiator in the thermal polymerizing photosensitive composition is in the range of 0.1 to 50% by mass, preferably from 0.5 to 30% by mass, and particularly from 1 to 20% by mass, of the total solid content. Compatibility between preferable sensitivity and scumming resistance in the non-imaging portions may be achieved in this range of the content.

A polymerization initiator containing the sulfonium salt polymerization initiator is particularly preferable in the invention. The sulfonium salt polymerization initiator may be used alone or two or more kinds of them, or the sulfonium salt polymerization initiator and other polymerization initiators may be used together. When two or more polymerization initiators are used in combination, a plurality of sulfonium salt polymerization initiators can be used, or the sulfonium salt polymerization initiator can be used in combination with another polymerization initiator. When the sulfonium salt polymerization initiator is used in combination with other polymerization initiator, the ratio (ratio by mass) of the sulfonium salt polymerization initiator to the other polymerization initiator is preferably 100/1 to 100/50, more preferably 100/5 to 100/25.

### (Polymerizing compound)

The polymerizing compound for use in the thermal polymerizing photosensitive composition is an addition-polymerizable compound having at least one ethylenically unsaturated double bond, and is selected from compounds having at least one, and preferably two or more ethylenically unsaturated bonds. These compounds are well known in the art, and may be used in the invention without any particular restriction. These compounds are present in various chemical forms of monomers, prepolymers such as dimers, trimers and oligomers, and mixtures thereof, and copolymers thereof. Examples of the monomers and copolymers thereof include unsaturated carboxylic acids (e.g., acrylic acid, methacrylic acid, itaconic acid, crotonic acid, isocrotonic acid, and maleic acid) and esters and amides thereof. Other examples thereof include esters of unsaturated carboxylic acids and aliphatic polyhydric alcohol compounds, and amides of unsaturated carboxylic acids and aliphatic polyvalent amine compounds. An adduct of an unsaturated carboxylic acid ester or amide having a nucleophilic substituent such as a hydroxyl group, an amino group, or a mercapto group, and a monofunctional or multifunctional isocyanate or an epoxy compound, and/or a dehydration condensation product from a monofunctional or multifunctional carboxylic acid is also preferably used. In addition, preferable are an adduct of an unsaturated carboxylic acid ester or amide having an electrophilic substituent such as an isocyanate group, or an epoxy group, and a monofunctional or multifunctional alcohol, amine, or thiol, and/or a substitution product from an unsaturated carboxylic acid ester or amide having a leaving substituent such as a halogen group, or a tosyloxy group, and a monofunctional or multifunctional alcohol, amine, or thiol. Further, it is possible to use a compound which is obtained in the same manner as those of the above compounds except that the unsaturated carboxylic acid is replaced with an unsaturated phosphonic acid, styrene, or vinyl ether.
A specific example of the polymerizable compound also includes the compound described as "the polymerizable compound having at least one ethylenically unsaturated group" in the photopolymerizing photosensitive composition.

Other examples of the esters include esters derived from aliphatic alcohol described in JP-B Nos. 46-27926 and 51-47334, and JP-ANo. 57-196231; compounds having an aromatic skeleton described in JP-A Nos. 59-5240, 59-5241, and 2-226149; and compounds having an amino group described in JP-ANo. 1-165613. Further, the above ester monomers may also be used as a mixture.

### (Binder polymer)

The binder polymer used in the thermal polymerizing photosensitive composition is contained in the photosensitive layer for the purpose of increasing film-forming property of the layer. Any polymer may be used as such if it improves the film-forming property. Among many polymers, the binder is preferably one having a repeating unit represented by the following Formula (i).

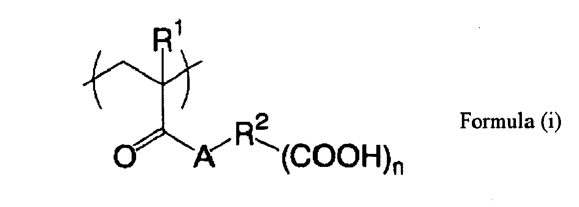

Hereinafter, the binder polymer having a repeating unit represented by the Formula (i) will be referred to as a specific binder polymer and described in detail.
R¹ in Formula (i) represents a hydrogen atom or a methyl group, and is preferably a methyl group.

The connecting group represented by R² in Formula (i) has two or more atoms selected from the group consisting of a carbon atom, a hydrogen atom, an oxygen atom, a nitrogen atom, and a sulfur atom and has 2 to 82 atoms in total.
More specific examples thereof include substituted and unsubstituted alkylenes, and substituted and unsubstituted arylenes. Further, the connecting group may have a structure wherein two or more of these bivalent groups are bound to each other via an amide bond or ester bond.
Examples of connecting groups having a chain structure include ethylene, and propylene. Such a connecting group can have a structure wherein two or more of these alkylenes are bound to each other via an ester bond.

Among them, the connecting group represented by R² in Formula (i) is preferably a hydrocarbon group having an alicyclic structure of 3 to 30 carbon atoms and a valency of (n+1). More specific examples thereof include hydrocarbon groups having a valency of (n+1) and prepared by removing (n+1) hydrogen atoms on carbon atoms of compounds having an alicyclic structure and optionally at least one substituent, such as cyclopropane, cyclopentane, cyclohexane, cycloheptane, cyclooctane, cyclodecane, dicyclohexyl, tercyclohexyl, and norbornane. Further, R² preferably has 3 to 30 carbon atoms, including carbon atoms of the substituent(s).

One or more carbon atoms of the compound having an alicyclic structure may be replaced with one or more hetero atoms selected from a nitrogen atom, an oxygen atom, and a sulfur atom. From the viewpoint of printing durability, R² is preferably a hydrocarbon group having 5 to 30 carbon atoms, containing two or more rings, having a valency of (n+1), having an alicyclic structure and optionally having at least one substituent, such as condensed polycyclic aliphatic hydrocarbon, cross-linked aliphatic hydrocarbon, spiro aliphatic hydrocarbon, and that in which aliphatic hydrocarbon rings are connected to each other directly or via a connecting group. When the compound has at least one substituent, the number of carbon atoms of the compound include those of the at least one substituent.

The connecting group represented by R² is particularly preferably a group having 5 to 10 atoms, and preferably has a chain structure having an ester bond or at least one of the cyclic structures described above.

The substituent(s) that may be introduced to the connecting group represented by R² can be a monovalent non-metal atomic group excluding hydrogen, and typical examples thereof include halogen atoms (-F, -Br, -Cl, and -I), a hydroxyl group, alkoxy groups, aryloxy groups, a mercapto group, alkylthio groups, arylthio groups, alkyldithio groups, aryldithio groups, an amino group, N-alkylamino groups, N,N-dialkylamino groups, N-arylamino groups, N,N-diarylamino groups, N-alkyl-N-arylamino groups, acyloxy groups, carbamoyloxy groups, N-alkylcarbamoyloxy groups, N-arylcarbamoyloxy groups, N,N-dialkylcarbamoyloxy groups, N,N-diarylcarbamoyloxy groups, N-alkyl-N-arylcarbamoyloxy groups, alkylsulfoxy groups, arylsulfoxy groups, acylthio groups, acylamino groups, N-alkylacylamino groups, N-arylacylamino groups, ureido groups, N'-alkylureido groups, N',N'-dialkylureido groups, N'-arylureido groups, N',N'-diarylureido groups, N'-alkyl-N'-arylureido groups, N-alkylureido groups, N-arylureido groups, N'-alkyl-N-alkylureido groups, N'-alkyl-N-arylureido groups, N',N'-dialkyl-N-alkylureido groups, N',N'-dialkyl-N-arylureido groups, N'-aryl-N-alkylureido groups, N'-aryl-N-arylureido groups, N',N'-diaryl-N-alkylureido groups, N',N'-diaryl-N-arylureido groups, N'-alkyl-N'-aryl-N-alkylureido groups, N'-alkyl-N'-aryl-N-arylureido groups, alkoxycarbonylamino groups, aryloxycarbonylamino groups, N-alkyl-N-alkoxycarbonylamino groups, N-alkyl-N-aryloxycarbonylamino groups, N-aryl-N-alkoxycarbonylamino groups, N-aryl-N-aryloxycarbonylamino groups, a formyl group, acyl groups, carboxyl groups and conjugated base groups, alkoxycarbonyl groups, aryloxycarbonyl groups, carbamoyl groups, N-alkylcarbamoyl groups, N,N-dialkylcarbamoyl groups, N-arylcarbamoyl groups, N,N-diarylcarbamoyl groups, N-alkyl-N-arylcarbamoyl groups, alkylsulfinyl groups, arylsulfinyl groups, alkylsulfonyl groups, arylsulfonyl groups, a sulfo group (-SO₃H) and conjugated base groups, alkoxysulfonyl groups, aryloxysulfonyl groups, sulfinamoyl groups, N-alkylsulfinamoyl groups, N,N-dialkylsulfinamoyl groups, N-arylsulfinamoyl groups, N,N-diarylsulfinamoyl groups, N-alkyl-N-arylsulfinamoyl groups, sulfamoyl groups, N-alkylsulfamoyl groups, N,N-dialkylsulfamoyl groups, N-arylsulfamoyl groups, N,N-diarylsulfamoyl groups, N-alkyl-N-arylsulfamoyl groups, N-acylsulfamoyl groups and conjugated base groups, N-alkylsulfonylsulfamoyl groups [-SO₂NHSO₂(alkyl)] and conjugated base groups, N-arylsulfonylsulfamoyl groups [-SO₂NHSO₂(aryl)] and conjugated base groups, N-alkylsulfonylcarbamoyl groups [-CONHSO₂(alkyl)] and conjugated base groups, N- arylsulfonylcarbamoyl groups [-CONHSO₂(aryl)] and conjugated base groups, alkoxysilyl groups [-Si(Oalkyl)₃], aryloxysilyl groups [-Si(Oaryl)₃], hydroxysilyl groups [-Si(OH)₃] and conjugated base groups, phosphono groups [-PO₃H₂] and conjugated base groups, dialkylphosphono groups [-PO₃(alkyl)₂], diarylphosphono groups [-PO₃(aryl)₂], alkylarylphosphono group [-PO₃(alkyl)(aryl)], monoalkylphosphono groups [-PO₃H(alkyl)] and conjugated base groups, monoarylphosphono groups [-PO₃H(aryl)] and conjugated base groups, phosphonooxy groups [-OPO₃H₂] and conjugated base groups, dialkylphosphonooxy groups [-OPO₃(alkyl)₂], diarylphosphonooxy groups [-OPO₃(aryl)₂], alkylarylphosphonooxy groups [-OPO₃(alkyl)(aryl)], monoalkylphosphonooxy groups [-OPO₃H(alkyl)] and conjugated base groups, monoarylphosphonooxy groups [-OPO₃H(aryl)] and conjugated base groups, a cyano group, a nitro group, dialkylboryl groups [-B(alkyl)₂], diarylboryl groups [-B(aryl)₂], alkylarylboryl groups [-B(alkyl)(aryl)], a dihydroxyboryl group [-B(OH)₂] and conjugated base groups, alkylhydroxyboryl groups [-B(alkyl)(OH)] and conjugated base groups, arylhydroxyboryl groups [-B(aryl)(OH)] and conjugated base groups, aryl groups, alkenyl groups, and alkynyl groups.

In the planographic printing plate used in the thermal polymerizing photosensitive composition, a substituent having a hydrogen atom which substituent can form a hydrogen bond, particularly a substituent having an acidic group that has an acid dissociation constant (pKa) smaller than that of a carboxylic acid is not preferable, since it tends to decrease printing durability. However, this substituent may be used depending on the design of a photosensitive layer. On the other hand, halogen atoms, hydrophobic substituents such as hydrocarbon groups (alkyl groups, aryl groups, alkenyl groups, and alkynyl groups), alkoxy groups, and aryloxyl groups are preferable, since they tend to improve printing durability. In particular, if the cyclic structure is a monocyclic aliphatic hydrocarbon having six or less members such as cyclopentane or cyclohexane, R² preferably has such a hydrophobic substituent. Two or more of these substituents may bind to each other or to a substituted hydrocarbon group to form a ring, and may have additionally a substituent thereon.

When A in Formula (i) is NR\ R³ represents a hydrogen atom or a monovalent hydrocarbon group having 1 to 10 carbon atoms. Examples of the monovalent hydrocarbon groups having 1 to 10 carbon atoms represented by R³ include alkyl groups, aryl groups, alkenyl groups, and alkynyl groups.
Typical examples of the alkyl groups include linear, branched, or cyclic alkyl groups having 1 to 10 carbon atoms such as a methyl group, an ethyl group, a propyl group, a butyl group, a pentyl group, a hexyl group, a heptyl group, an octyl group, a nonyl group, a decyl group, an isopropyl group, an isobutyl group, a sec-butyl group, a tert-butyl group, an isopentyl group, a neopentyl group, a 1-methylbutyl group, an isohexyl group, a 2-ethylhexyl group, a
2-methylhexyl group, a cyclopentyl group, a cyclohexyl group, a 1-adamantyl group, and a 2-norbornyl group.

Typical examples of the aryl group include aryl groups having 1 to 10 carbon atoms such as a phenyl group, a naphthyl group, and an indenyl group; and heteroaryl groups having 1 to 10 carbon atoms and containing a hetero atom selected from the group consisting of a nitrogen atom, an oxygen atom and a sulfur atom such as a furyl group, a thienyl group, a pyrrolyl group, a pyridyl group, and a quinolyl group.
Typical examples of the alkenyl group include linear, branched, or cyclic alkenyl groups having 1 to 10 carbon atoms such as a vinyl group, a 1-propenyl group, a 1-butenyl group, a 1-methyl-1-propenyl group, a 1-cyclopentenyl group, and a 1-cyclohexenyl group.

Typical examples of the alkynyl group include alkynyl groups having 1 to 10 carbons such as an ethynyl group, a 1-propynyl group, a 1-butynyl group, and a 1-octynyl group. The substituent(s) which R³ may have is the same as those which R² may have. The number of carbon atoms of R³ is 1 to 10, including the carbon atoms of the substituent(s).
A in Formula (i) is preferably an oxygen atom or -NH-, since such a compound is easy to produce.
In Formula (i), n is an integer of 1 to 5, and preferably 1 from the viewpoint of printing durability.
Typical examples of the repeating unit represented by Formula (i) are shown below, but the invention is not limited by these examples.

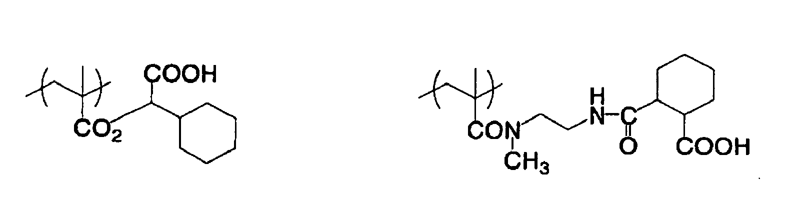

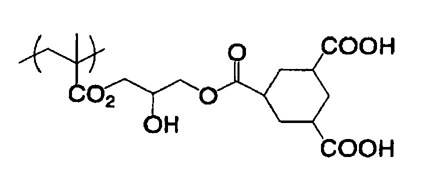

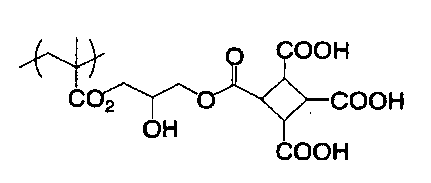

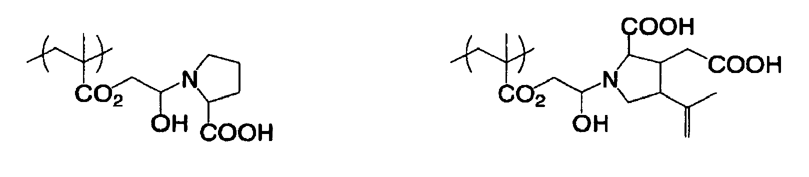

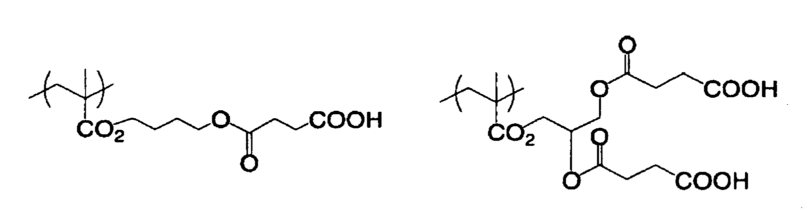

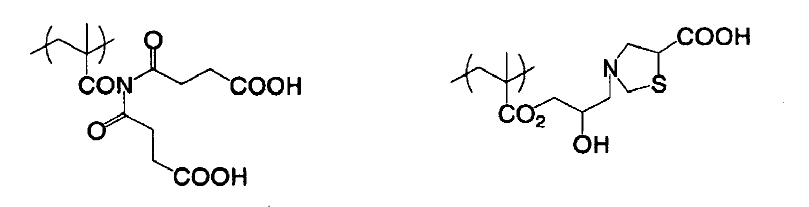

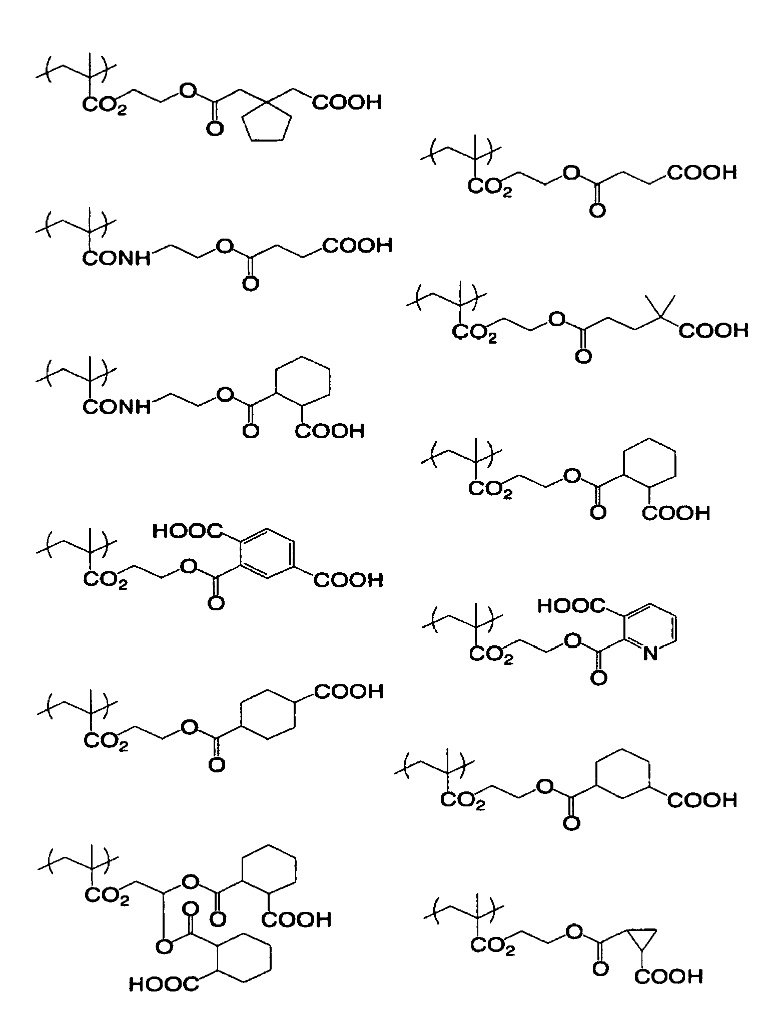

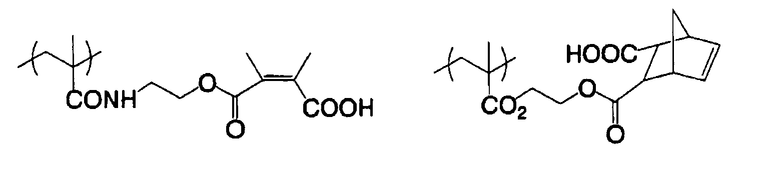

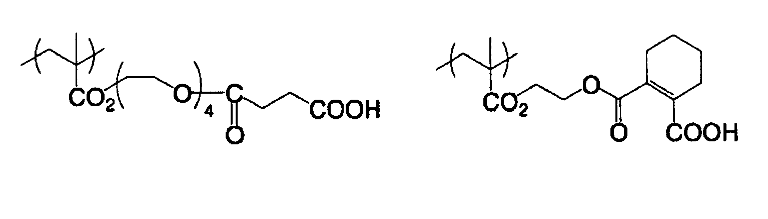

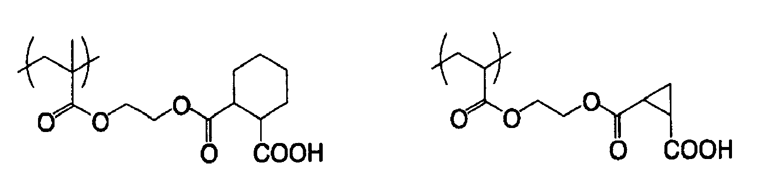

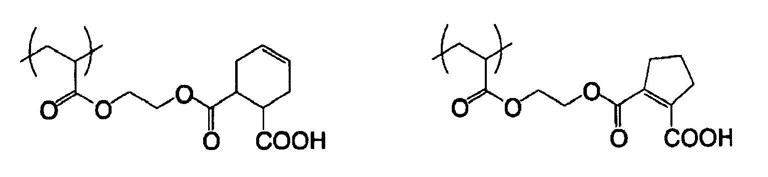

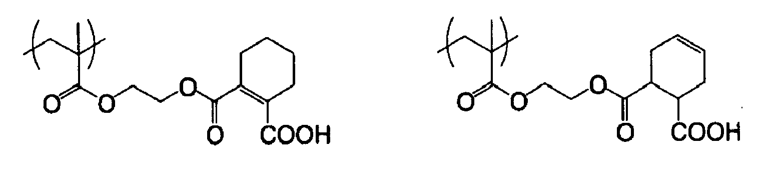

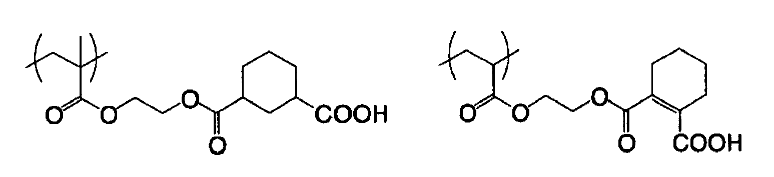

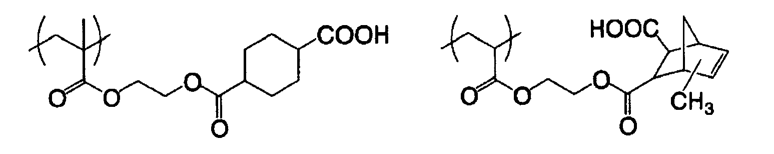

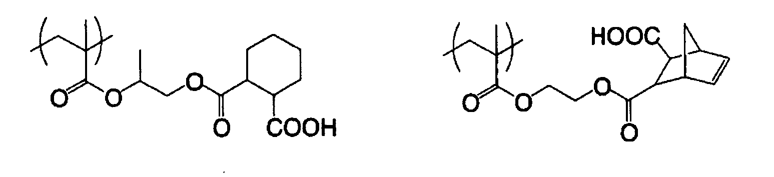

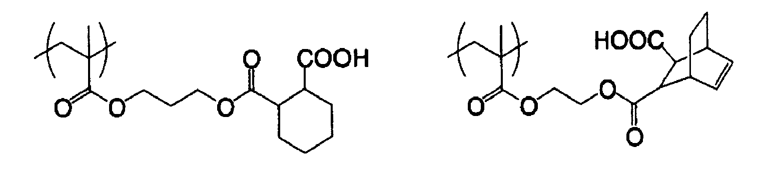

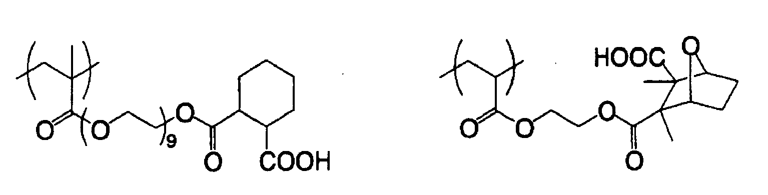

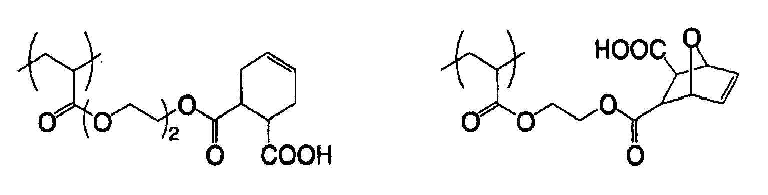

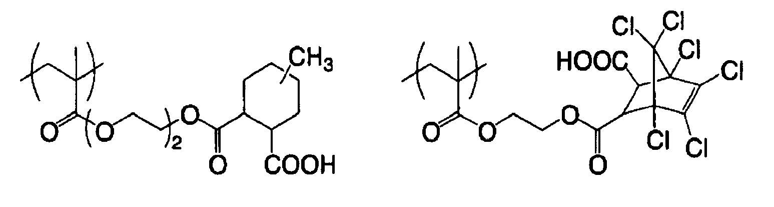

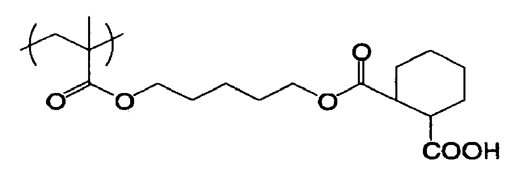

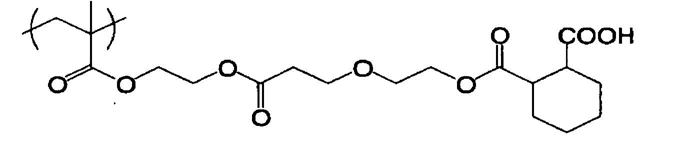

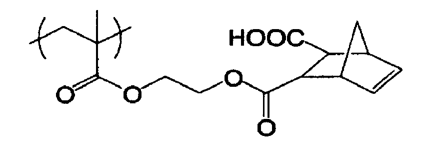

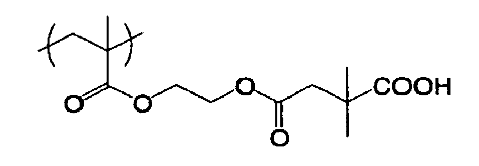

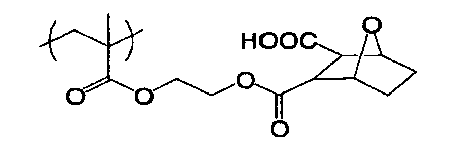

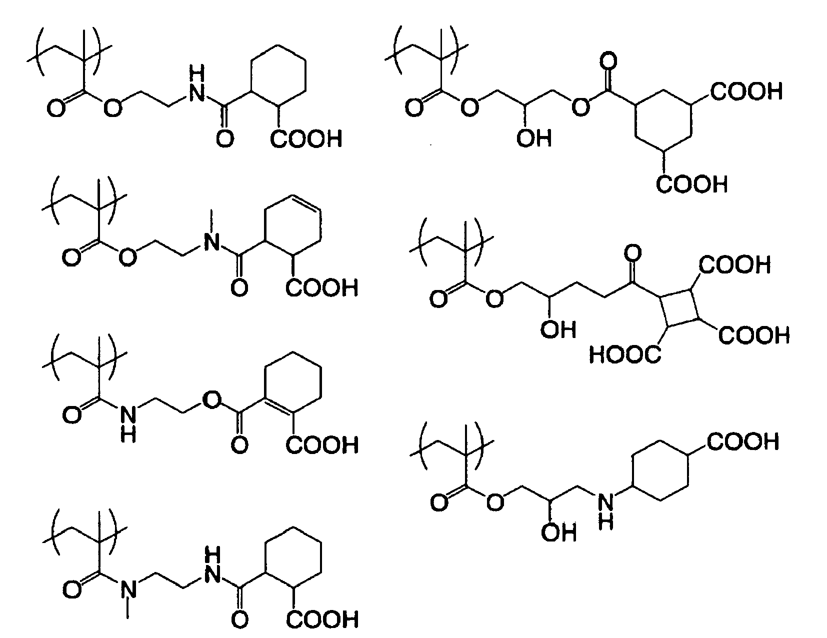

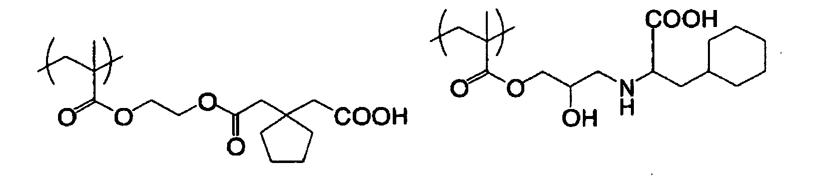

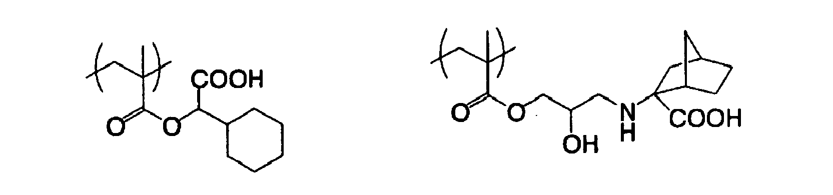

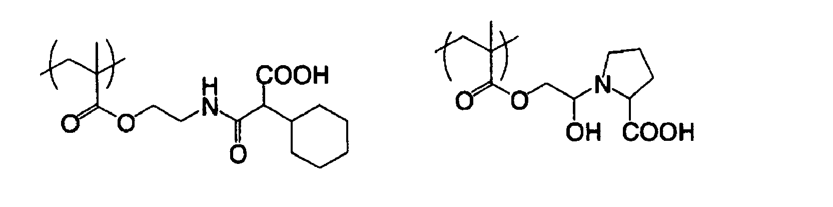

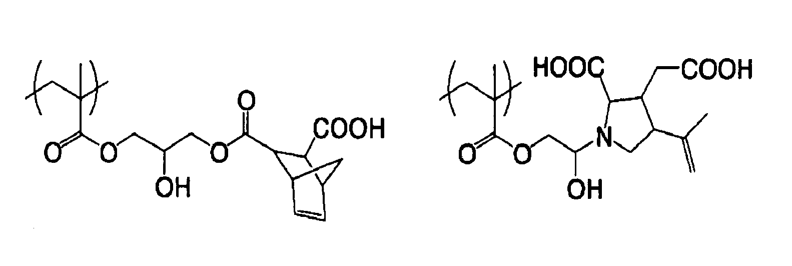

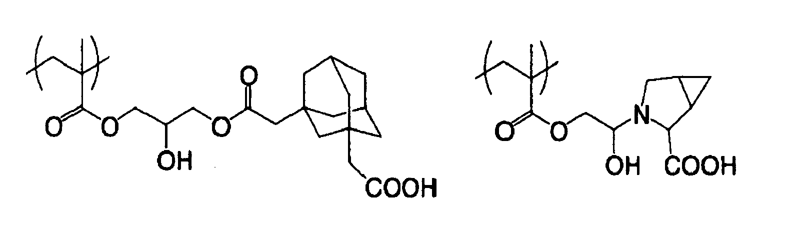

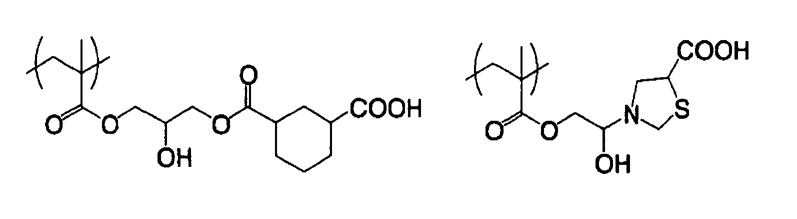

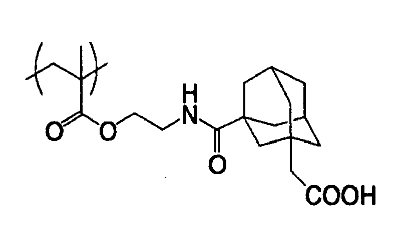

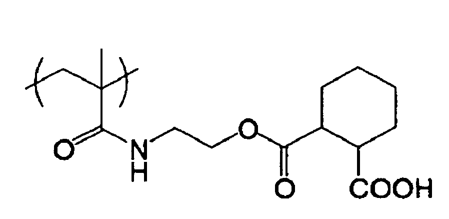

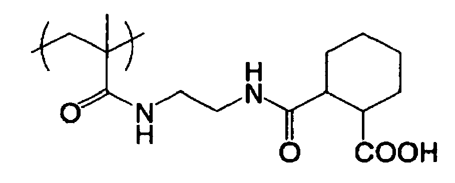

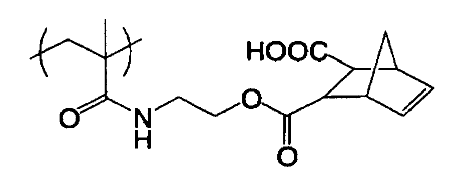

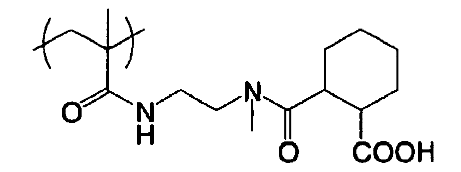

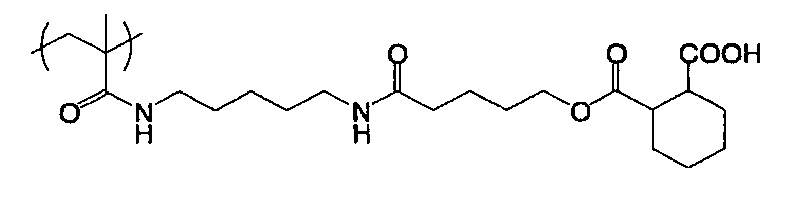

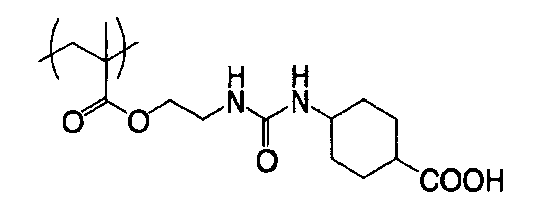

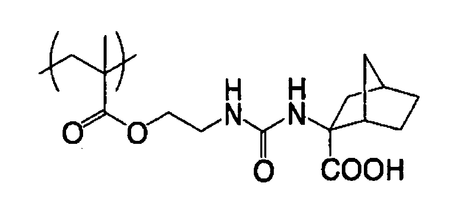

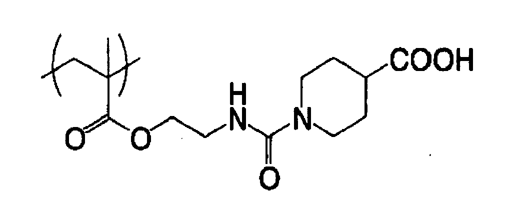

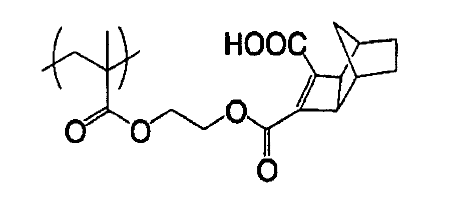

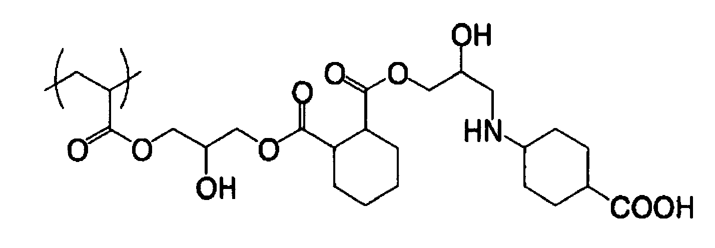

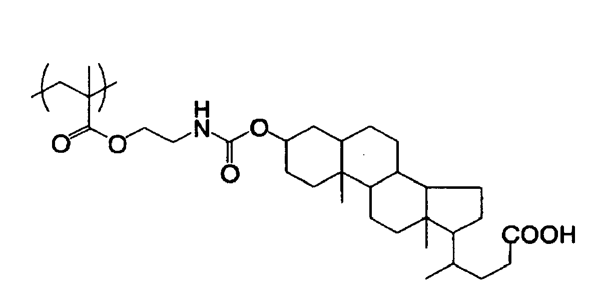

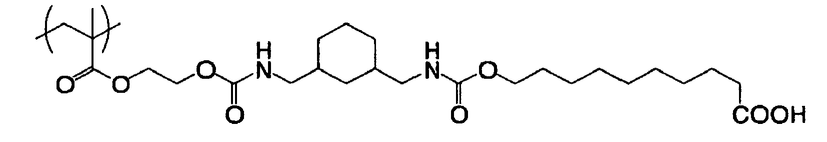

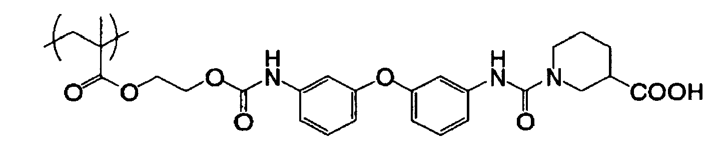

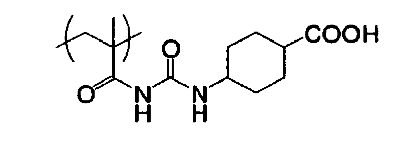

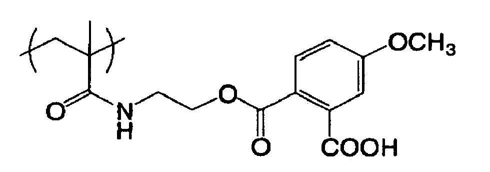

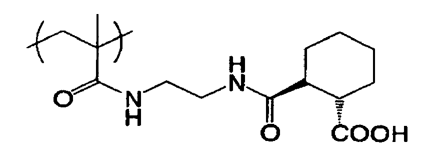

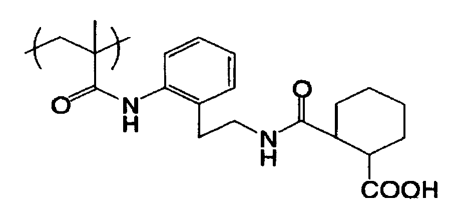

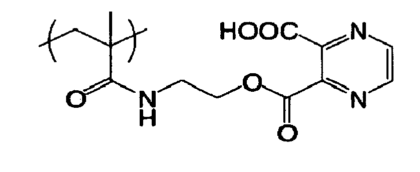

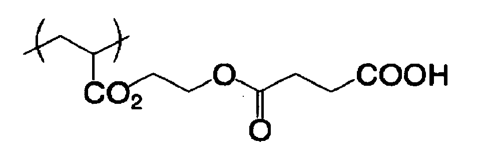

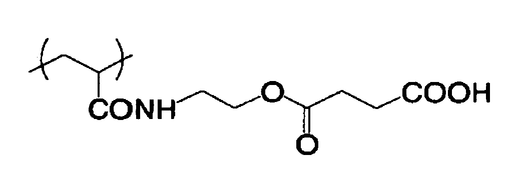

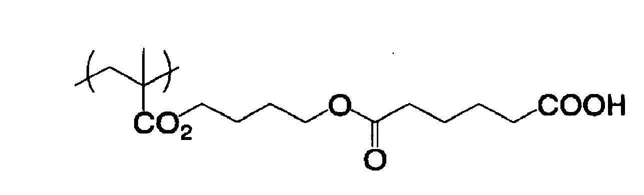

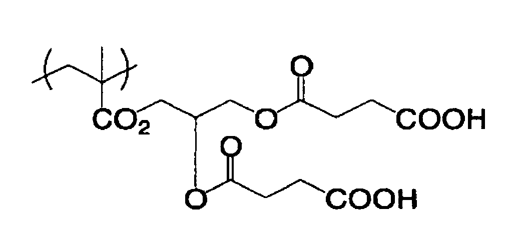

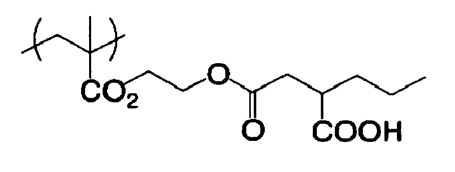

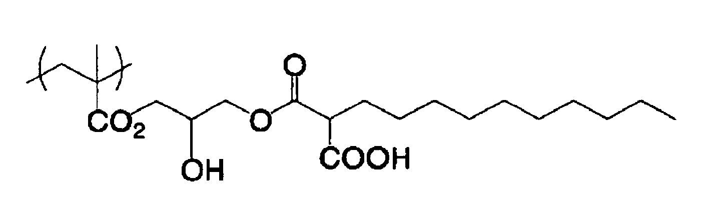

The binder polymer may have one or more of the repeating units represented by Formula (i). The specific binder polymer used in the invention may be a polymer consisting only of the repeating unit(s) represented by Formula (i), but is usually a copolymer in which at least one repeating unit described above is copolymerized with one or more other copolymerizable components. The total content of the repeating unit(s) represented by Formula (i) in the copolymer may be determined suitably according to the structure of the copolymer and the design of a composition, but is preferably in the range of 1 to 99 mole%, more preferably 5 to 40 mole%, and still more preferably 5 to 20 mole% with respect to the total number of moles of the polymer components.

Any known radical polymerizable monomer may be used as the copolymerizable component without restriction. Specific examples thereof include those described in "Polymer Data Handbook -Basic- (edited by Soc. Polymer Science, Japan, and published by Baihukan in 1986)". One copolymerizable component may be used alone, or two or more copolymerizable components can be used together.

The molecular weight of the specific binder polymer of the invention is appropriately determined from the viewpoint of image forming property and printing durability of the photosensitive planographic printing plate. Usually, a higher molecular weight tends to deteriorate image-forming characteristics, although printing durability is excellent. On the contrary, a lower molecular weight improves image-forming characteristics, although printing durability decreases. The molecular weight is preferably from 2,000 to 1,000,000, more preferably from 5,000 to 500,000, and further preferably from 10,000 to 200,000.

The binder polymer used in the invention may be one specific binder polymer or a mixture of at least one specific binder polymer and one or more other binder polymers. Other binder polymer(s) is contained in an amount in the range of 1 to 60% by mass, preferably 1 to 40% by mass, and still more preferably 1 to 20% by mass with respect to the total weight of the binder polymer(s) component. Any known polymer may be used as other binder polymer without restriction, and typical examples thereof include binders having an acrylic main chain and urethane binders, which are commonly used in the art.

The total amount of the specific binder polymer(s) and other binder polymer(s) in the composition may be determined suitably, but is generally in the range of 10 to 90%, preferably 20 to 80%, and still more preferably 30 to 70% by mass with respect to the total mass of the nonvolatile components of the composition.
The acid value (meq/g) of the binder polymer is preferably in the range of 2.00 to 3.60.

### -Other binder polymer used together with specific binder polymer-

Other binder polymer used together with specific binder polymer is preferably a binder polymer having a radically polymerizable group.
The radically polymerizable group is not particularly limited, as long as it can be polymerized by a free radical. Examples thereof include α-substituted methylacrylic groups [-OC(=O)-C(-CH₂Z)=CH₂] wherein Z is a hydrocarbon group having a hetero atom bonded to the CH₂ group, an acrylic group, a methacrylic group, an allyl group, and a styryl group. The radically polymerizable group is preferably an acrylic group and/or a methacrylic group.

Preferably, the binder polymer further has an alkali-soluble group. The content of the alkali-soluble group (acid value determined by neutralization titration) in the binder polymer is preferably 0.1 to 3.0 mmol, more preferably 0.2 to 2.0 mmol, and most preferably 0.45 to 1.0 mmol, per g of the binder polymer. When the content is lower than 0.1 mmol, the binder polymer may be precipitated during development to generate development scum. When the content is higher than 3.0 mmol, the hydrophilicity of the binder polymer may be too high, thus printing durability may deteriorate when applied to the photosensitive planographic prining plate.

The photosensitive composition may contain, in addition to the primary components described above, other components suitable for application, and the production method thereof. Hereinafter, preferable examples of additives which the photosensitive composition may have will be described.

### (Polymerization inhibitor)

A small amount of a heat-polymerization inhibitor is preferably added to the photosensitive composition of the present invention in order to inhibit undesired heat polymerization of the polymerizable compound having an ethylenically unsaturated double bond. Preferable examples of the heat-polymerization inhibitor include hydroquinone, p-methoxyphenol, di-t-butyl-p-cresol, pyrogallol, t-butyl catechol, benzoquinone, 4,4'-thiobis(3-methyl-6-t-butyl phenol), 2,2'-methylene bis(4-methyl-6-t-butyl phenol), N-nitrosophenyl hydroxyamine primary cerium salts, etc. The amount of the heat-polymerization inhibitor added is preferably about 0.01 to about 5% by mass relative to the weight of nonvolatile components in the entire composition. To prevent the inhibition of polymerization by oxygen, a higher fatty acid derivative such as behenic acid or behenic amide may be added as necessary so that it is allowed to be locally present on the surface of the photosensitive layer in the drying step after application. The amount of the higher fatty acid derivative added is preferably about 0.5 to about 10% by mass relative to nonvolatile components in the entire composition.

### (Coloring agent)

Dyes or pigments may be added to the thermal polymerizing photosensitive composition for the purpose of coloring. The plate-checking property, that is, the visibility of the printing plate after plate-making and the applicability for image densitometer can thereby be improved when the composition is applied to the printing plate. When dyes are used as the coloring agent, many of these can cause a reduction in the sensitivity of the photo-polymerizable photosensitive layer, and thus, it is particularly preferable to use pigments as the coloring agent. Examples of the coloring agent include pigments such as phthalocyanine type pigments, azo type pigments, carbon black and titanium oxide, and dyes such as ethyl violet, crystal violet, azo type dyes, anthraquinone type dyes and cyanine type dyes. The amount of the dyes and pigments added is preferably about 0.5 to about 5% by mass of nonvolatile components in the entire composition.

### (Other additives)

Known additives such as inorganic fillers for improving the physical properties of the cured layer, as well as other plasticizers and sensitizers for improving inking properties on the surface of the photosensitive layer may also be added. The plasticizers include dioctyl phthalate, didodecyl phthalate, triethylene glycol dicaprylate, dimethyl glycol phthalate, tricresyl phosphate, dioctyl adipate, dibutyl sebacate, triacetyl glycerin, etc., and these can be added in an amount of 10% by mass or less relative to the total weight of the binder polymer and the addition-polymerizable compound. UV initiators and heat-crosslinking agents for enhancing the effect of heating and irradiation after development can also be added for the purpose of improving the layer strength (printing durability) described later.

The thermal polymerizing photosensitive composition or photopolymerizing photosensitive composition described above may be favorably used as the photosensitive layer of the photosensitive planographic printing plate to be described below.

### [Photosensitive planographic printing plate]

The precursor of the photosensitive planographic printing plate to which the plate making method of the invention is applied comprises a photosensitive layer and protective layer arbitrarily and sequentially laminated on the support, wherein the photosensitive layer comprises the photosensitive composition described above. The photosensitive planographic printing plate may be produced by coating a coating solution of the photosensitive layer containing the photosensitive composition, and a solution prepared by dissolving coating solution components for a desired layer such as a protective layer in a solvent, on an appropriate support or intermediate layer.

### [Photosensitive layer]

The photosensitive layer is a negative type photosensitive layer containing the photosensitive component, particularly the photopolymerizing photosensitive component or thermal polymerizing photosensitive component. Such photopolymerizing or thermal polymerizing negative type photosensitive layer has a mechanism comprising the steps of decomposing a polymerization initiator by light or heat to generate radicals, and permitting a polymerizable compound to initiate a polymerization reaction by the radical generated. The photosensitive planographic printing plate having the photosensitive layer is particularly suitable for forming a printing plate for directly drawing an image with a laser light at a wavelength of 300 to 1,200 nm, and is able to exhibit better printing durability and image forming property as compared with conventional photosensitive planographic printing plate.

The coating amount of the photosensitive layer mainly affects the sensitivity and developability of the photosensitive layer and the strength and printing durability of the layer exposed to light, and is desirably selected depending on the use. When the coating amount is too low, the printing durability is not sufficient. It is not preferable for the coating amount to be too high because sensitivity is reduced, light exposure requires more time, and a longer time is necessary for development processing. The coating amount on the photosensitive planographic printing plate for scanning light exposure as the major object of the present invention is preferably in the range of about 0.1 to 10 g/m², and more preferably 0.5 to 5 g/m², in terms of dried weight.

### [Support]

The support of the photosensitive planographic printing plate of the invention is an aluminum support having a hydrophilic surface.
The aluminum plate is a metal plate based on dimensionally stable aluminum, and is selected not only from a pure aluminum plate but also from an alloy plate based on aluminum containing a very small amount of different elements. In the following description, the substrates made of aluminum or aluminum alloys are referred to collectively as the aluminum substrate. The different elements contained in the aluminum alloy include silicon, iron, manganese, copper, magnesium, chromium, zinc, bismuth, nickel, titanium etc. The content of the different elements in the alloy is up to 10% by mass. Particularly preferable aluminum in the present invention is a pure aluminum plate, but because production of absolutely pure aluminum by refining techniques is difficult, aluminum may contain a very small amount of different elements. The composition of the aluminum plate thus used in the present invention is not limited, and any aluminum plates made of a known and conventionally used aluminum material such as JIS A 1050, JIS A 1100, JIS A 3103 and JIS A 3005 can be used as necessary.
The thickness of the aluminum plate is about 0.1 to 0.6 mm. This thickness can be suitably changed depending on the size of a printing machine, the size of a printing plate, and user's demands. The aluminum plate may or may not be subjected to substrate surface treatment described later.

### (Surface roughening treatment)

Examples of a surface roughening method include mechanical surface roughening, chemical etching, and electrolytic graining disclosed in JP-A No. 56-28893. In addition, a mechanical surface roughening method such as an electrochemical surface roughening method of electrochemically roughening an aluminum support surface in a hydrochloric or nitric acid electrolyte, a wire brush graining method of scratching an aluminum support surface with metal wires, a ball graining method of roughening an aluminum support surface with abrasive balls and an abrasive; or a brush graining method of roughening an aluminum support surface with a nylon brush and an abrasive can be conducted as the surface roughening method. One of these surface roughening methods may be conducted, or two or more of them can be conducted. Among the surface roughening methods described above, preferable is the electrochemical method of chemically roughening an aluminum support surface in a hydrochloric or nitric acid electrolyte, and the amount of anodic electric current (current when the support serves as a positive electrode) is preferably in the range of 50 to 400 C/dm². More specifically, the alternate current and/or direct current electrolysis is preferably carried out in an electrolyte containing 0.1 to 50% of hydrochloric or nitric acid at a temperature of 20 to 80°C at an electric current density of 100 to 400 C/dm² for a period of 1 second to 30 minutes.

The aluminum support subjected to the surface roughening treatment may be further chemically etched in an acid or alkali. Typical examples of the etching agent include sodium hydroxide, sodium carbonate, sodium aluminate, sodium metasilicate, sodium phosphate, potassium hydroxide, and lithium hydroxide. The concentration and the temperature are preferably 1 to 50%, and 20 to 100°C, respectively. After etching, the support is washed with an acid to remove stains remaining on the support surface (smuts). The acid is preferably nitric acid, sulfuric acid, phosphoric acid, chromic acid, hydrofluoric acid, and/or borofluoric acid. In particular, a method for removing smuts after electrochemical surface roughening treatment is preferably a method described in JP-A No. 53-12739 wherein the support surface is brought into contact with 15 to 65% by mass of sulfuric acid at a temperature of 50 to 90°C, and/or a method described in JP-B 48-28123 wherein the surface is alkaline-etched. The method for removing smuts and conditions therefor are not particularly limited, as long as the surface roughness of the treated surface Ra is about 0.2 to 0.5 µm.

### (Anodizing process)

The aluminum support on which an oxide layer is formed in the above manner are subjected to anodizing treatment. In the anodizing treatment, one or at least two of aqueous solutions of sulfuric acid, phosphoric acid, oxalic acid, and boric acid/sodium borate are used as the main component(s) of the electrolytic solution contained in an electrolytic bath. The electrolyte solution may contain other components commonly contained in the aluminum alloy plate, the electrodes, tap water, and underground water. In addition, the electrolyte solution may also contain second and third components. Examples of the second and third components include cations including metal ions such as Na, K, Mg, Li, Ca, Ti, Al, V, Cr, Mn, Fe, Co, Ni, Cu, and Zn, and an ammonium ion; and anions such as nitrate, carbonate, chloride, phosphate, fluoride, sulfite, titanate, silicate, and borate ions. The concentration thereof in the electrolyte solution may be about 0 to 10,000 ppm. Conditions of the anodizing treatment are not particularly limited, but the support is preferably subjected to direct or alternate current electrolysis at 30 to 500 g/L at a processing solution temperature of 10 to 70°C at an electric current density of 0.1 to 40 A/m². The thickness of the anodic oxidation film formed is in the range of 0.5 to 1.5 µm, and preferably in the range of 0.5 to 1.0 µm. Conditions of the anodic oxidation are preferably selected so that the diameter and density of micropores present in the anodic oxidation film of the support prepared as described above respectively become 5 to 10 nm and 8×10¹⁵ to 2×10¹⁶ pores/m².

Any method known in the art may be used in making the support surface hydrophilic. Particularly preferable is treatment of making the support surface hydrophilic with silicate, or polyvinyl phosphonic acid. The film is formed such that the amount of silicon or phosphor element is preferably 2 to 40 mg/m², and more preferably 4 to 30 mg/m². The coating amount can be measured in accordance with a fluorescent X-ray analytic method.

The treatment of making a support surface hydrophilic can be carried out, for example, by immersing an aluminum support on which an anodic oxidation film is formed in an aqueous solution containing an alkali metal silicate or polyvinylphosphonic acid at a concentration of 1 to 30%, and preferably 2 to 15% by mass, and having a pH at 25°C in the range of 10 to 13 at a temperature of 15 to 80°C for a period of 0.5 to 120 seconds.

For the purpose of preventing tinting and improving adhesiveness between the photosensitive layer and the substrate, an intermediate layer may be arranged in the photosensitive planographic printing plate in the present invention. Examples of the intermediate layer which can be preferably used include those described in the following publications and specifications.
Examples of such intermediate layers include those described in JP-B No. 50-7481, JP-ANos. 54-72104, 59-101651, 60-149491, 60-232998, 3-56177, 4-282637, 5-16558, 5-246171, 7-159983, 7-314937, 8-202025, 8-320551, 9-34104, 9-236911, 9-269593, 10-69092, 10-115931, 10-161317, 10-260536, 10-282682, 11-84674, Japanese Patent Application Laid-Open (JP-A) Nos. 8-225335, 8-270098, 9-195863, 9-195864, 9-89646, 9-106068, 9-183834, 9-264311, 9-127232, 9-245419, 10-127602, 10-170202, 11-36377, 11-165861, 11-284091, and 2000-14697.

### [Protective layer (overcoat layer)]

A protective layer is preferably provided on the photosensitive layer. The protective layer prevents low molecular weight compounds such as oxygen and basic substances in the air, which inhibit an image-forming reaction caused by exposure in the photosensitive layer, from being mingled into the photosensitive layer, and permits exposure in the air. While the protective layer is principally provided for protecting the photosensitive layer, it also serves as an oxygen-blocking layer when the photosensitive layer has a radical-polymerizable image forming mechanism, while functions as an abrasion preventive layer when the photosensitive layer is exposed to a high illuminance infrared laser. The desired characteristics of the protective layer are that the protective layer does not substantially inhibit transmission of light used in light exposure, is excellent in adhesion to the photosensitive layer, and can be removed easily in the development step after exposure to light. The protective layer has been devised and is described in detail in US Patent No. 3,458,311 and JP- B No. 55-49729.

The materials usable in the protective layer are preferably water-soluble polymers possessing relatively excellent crystallinity, and examples thereof include water-soluble polymers such as polyvinyl alcohol, vinyl alcohol/vinyl phthalate copolymers, vinyl acetate/vinyl alcohol/vinyl phthalate copolymers, vinyl acetate/crotonic acid copolymers, polyvinyl pyrrolidone, acidic celluloses, gelatin, gum arabic, polyacrylic acid and polyacrylamide, and these can be used alone or in admixture. Among these compounds, polyvinyl alcohol can be used as a major component to give the best result to basic characteristics such as oxygen impermeability and removability by development.
Other characteristics desirable for the protective layer are that the precursor of the planographic printing plate does not stick to the back surface of an adjoining printing plate when many plates are directly laminated without interposition of a paper sheet between the plates the protective layer for feeding or storing the plates; the protective layer does not stick to the paper sheet when many precursors of the planographic printing plate and the paper sheets are alternately laminated for feeding or storing the plates; and the protective layer can be readily removed in the development step after the exposure step.

The polyvinyl alcohol (PVA) used in the protective layer may be partially replaced by ester, ether and acetal insofar as it has unsubstituted vinyl alcohol units for giving necessary oxygen impermeability and water solubility. Similarly, it may partially have other copolymerizable components. Examples of the polyvinyl alcohol include those hydrolyzed at a degree of 71 to 100%, having 300 to 2400 repeating units. Specific examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, L-8, etc. which are available from Kuraray Co., Ltd.

Mica compounds such as mica particles are preferably added to the protective layer for preventing printing plates to stick to one another in the precursor of the planographic printing plate required to be handled by laminating many plates. Examples of such mica compounds include those represented by a formula A(B,C)₂-5D₄O₁₀(OH, F, O)₂ (wherein A is any one of K, Na and Ca; B and C are any one of Fe(II), Fe(III), Mn, Al, Mg and V; and D is Si or Al).

Examples of the compound belonging to the mica compounds (mica group) include natural mica such as white mica, paragonite, bronze mica (phlogopite), black mica (biotite) and lepidolite. Examples of the synthetic mica include non-swellable mica such as fluorine bronze mica KMg₃(AlSi₃O₁₀)F₂, potassium tetrasilicon mica KMg_{2.5}(Si₄O₁₀)F₂, and swellable mica such as sodium-tetrasililic mica NaMg_{2.5}(Si₄O₁₀)F₂, sodium or lithium teniolite (Na, Li)Mg₂Li(Si₄O₁₀)F₂, and sodium or lithium hectlite (Na, Li)_{1/8}Mg_{2/5}Li_{1/8}(Si₄O₁₀)F₂ belonging to montmorillonite. Synthetic smectite is also useful.

Fluorine-base swellable mica is particularly useful among the mica compounds. This swellable synthetic mica has a laminated structure composed of unit crystal lattice layers with a thickness of about 10 to 15 Å, and the number of substitution number of metal atoms in the crystal lattice is remarkably larger than that of other clay minerals. Consequently, the lattice layer is deficient in positive charges, and cations such as Na⁺, Ca²⁺ and Mg²⁺ are adsorbed in the inter-lattice layer for compensating the deficient charge. The cations interposed between the layers are called as exchangeable cations, and are able to be replaced with various cations. Bonding force between the crystal lattice layers is weak when the interlayer cations comprise Li⁺ and Na⁺ due to their small ionic radii, and the crystal lattice is largely swelled with water. Accordingly, the mica crystal is readily cleaved by applying a shear force, and form stable sol in water. The synthetic swellable mica is useful and particularly preferable since it has a strong tendency for this phenomenon.

The thinner the thickness of the mica compound is the better from the viewpoint of diffusion control, and the larger the planar size is the better so long as smoothness of the coating surface and permeability of the active light is not inhibited. Accordingly, the aspect ratio is 20 or more, preferably 100 or more, and particularly 200 or more. The aspect ratio refers to the ratio of the thickness to the major axis of the particle, and can be measured, for example, from a projection of the particle under a microgram. A larger aspect ratio gives a better effect.

The average major axis of the particle diameter of the mica compound of the printing plate used in the invention is in the range of 0.3 to 20 µm, preferably from 0.5 to 10 µm, and particularly 1 to 5 µm. The average thickness of the particle is 0.1 µm or less, preferably 0.05 µm or less, and particularly 0.01 µm or less. Specifically, the size of the swellable synthetic mica as a representative compound is from 1 to 50 nm in the thickness and from 1 to 20 µm in the surface size (major axis).

The content of the mica compound in the protective layer is preferably in the range of 5 to 50% by mass, more preferably from 8 to 40% by mass, relative to the amount of the total solid content of the protective layer. Effects for suppressing adhesion between the precursors of the planographic printing plate to one another and for suppressing generation of spoils may be obtained, proper permeation of oxygen and fog-preventive effect by a UV-cut light may be achieved, and sensitivity does not decrease due to a decrease in transparency of the coating film of the protective layer in the range of the mica content as described above.
The total amount of the compound is prefarably within the mass ratio described above when a plurality of the mica compounds are used.

At least an exposure process and a development process are applied before making the planographic printing plate from the photosensitive planographic printing plate.

### [Exposure step of the thermal polymerizing photosensitive planographic printing plate]

An infrared laser is an example of the light source suitable in the exposure step of the thermal polymerizing photosensitive planographic printing plate in the plate making method of the invention. Thermal recording by a UV lamp and a thermal head is also possible.
The image is preferably exposed to a solid laser and semiconductor laser that emits an infrared light with a wavelength in the region from 750 nm to 1,400 nm. The output power of the laser is preferably 100 mW or higher, and a multi-beam laser device is preferably used for shortening the exposure time. The exposure time per one pixel is preferably 20 µsecs or less. The energy irradiated to the photosensitive planographic printing plate is preferably from 10 to 300 mJ/cm². Curing of the photosensitive layer is not sufficiently advanced when the exposure energy is too low, while the photosensitive layer is abraded by the laser light to damage the image when the exposure energy is too high.

In the exposure in the invention, the light beams from a light source may be overlapped. The overlap means that a sub scanning pitch width is smaller than the diameter of a beam. For example, when a beam diameter is expressed by the full width at the half maximum intensity (FWHM), the degree of overlap can be expressed quantitatively by an overlapping coefficient, FWHM/sub scanning pitch width. In the invention, the overlapping coefficient is preferably 0.1 or more.

A method of scanning a planographic plate with a light source of an exposure apparatus used in the exposure step is not particularly restricted, and the exposure may be carried out either by scanning the external or internal wall of a cylinder to which external or internal wall a printing plate is attached, or the surface of a printing plate disposed flat. The light source may be single-channel type or multi-channel type, but a multi-channel light source is preferably used for scanning the external surface of a cylinder to which external surface a printing plate is attached.

The printing plate may be developed immediately after exposure, or may be heated between the exposure step and development step in the invention. The heating condition is preferably from 5 seconds to 5 minutes at a temperature from 60 to 150°C.

In the present invention, a pre-washing with water to remove the protective layer may be carried out before the development step. In pre-washing, tap water for example is used.

The thermal polymerizing planographic printing plate is developed with the developer of the invention after exposure (after the exposure and heating steps), followed by rinsing with water.

The planographic printing plate developed in this manner may be post-treated with a rinsing solution containing a surfactant, and a desensitizing solution containing gum arabic, and/or a starch derivative, as described in JP-A Nos. 54-8002, 55-115045, and 59-58431. Various combinations of these treatments may be used as the post-treatment of the planographic printing plate used in the invention.

In the method of making a planographic printing plate according to the invention, the developed images may be heated or the entire surface thereof may be irradiated for the purpose of improving image strength and printing durability.
Very severe conditions may be used in the heating after development. Normally, the planographic printing plate is heated at a heating temperature in the range of 200 to 500°C. A lower heating temperature after development does not allow sufficient strengthening of the image, while a higher heating temperature may result in deterioration of the support and thermal decomposition of the image portions.

The planographic printing plate prepared in this manner is set in an offset printing machine and used for printing on a number of sheets of paper.
A plate cleaner used to remove stains on the plates during printing is a conventionally known plate cleaner for PS plates, and examples thereof include CL-1, CL-2, CP, CN-4, CN, CG-1, PC-1, SR, and IC (manufactured by Fuji Photo Film Co. Ltd.).
The negative type recording layer processed with the replenisher of the invention is preferably a recording layer comprising a compound that generates radicals by a light or heat, a polymerizable compound and a radiation absorber.
The surfactant is selected from a group consisting of at least one of the surfactants represented by formulae (1-A) and (1-B) below, and the content thereof is preferably in the range of 1.0% by mass to 10% by mass.

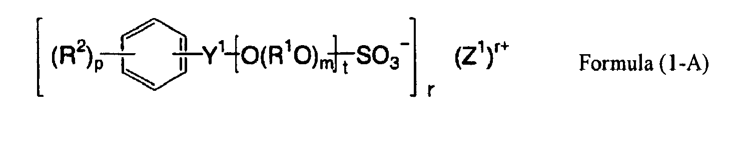

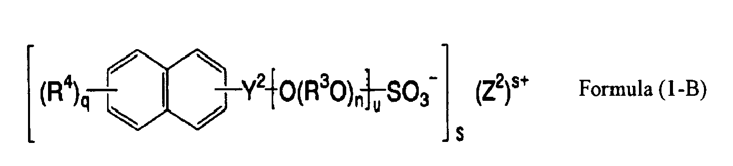

In the formulae (1-A) and (1-B), R¹ and R³ each independently represents a linear or branched alkylene group having 1 to 5 carbon atoms, and R² and R⁴ each independently represents a linear or branched alkyl group having 1 to 20 carbon atoms. r and s each independently represents 0,1 or 2. Y¹ and Y² each independently represents a single bond or an alkylene group having 1 to 10 carbon atoms, and n and m each independently represents an integer of 1 to 100. Plural R¹ and R³ may be the same or different to one another when n or m are 2 or more. t and u each independently represents 0 or 1. Z¹ and Z² each independently represent an alkali metal ion, an alkali earth metal ion, or a non-substituted ammonium ion or an ammonium ion substituted with an alkyl group. p and q each independently represents an integer selected from 0 to 2.
The content of the chelating agent is in the range of 15 to 200 mmol/L, and the chelating agent is preferably a hydroxycarboxylic acid.
The negative type recording layer of the precursor of the planographic printing plate used in the invention is preferably a recording layer comprising a compound that generates radicals by a light or heat, a polymerizable compound, and a radiation absorber.

The surfactant contained in the developer or replenisher used in the plate making method of the invention is the one selected from a group consisting of at least one of the surfactants represented by following formulae (1-A) and (1-B), and the content of the surfactant is preferably in the range of 1.0 to 10% by mass.

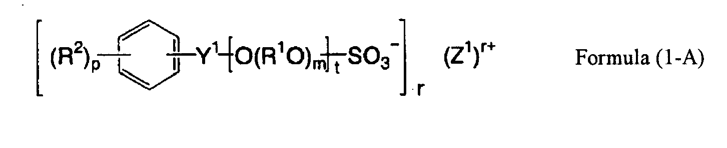

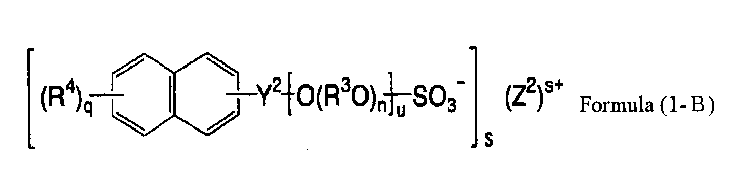

In the formulae (1-A) and (1-B), R¹ and R³ each independently represents a linear or branched alkylene group having 1 to 5 carbon atoms, and R² and R⁴ each independently represents a linear or branched alkyl group having 1 to 20 carbon atoms. r and s each independently represents an integer of 0, 1 or 2. Y¹ and Y² each independently represents a single bond or an alkylene group having 1 to 10 carbon atoms, and n and m each independently represents an integer of 1 to 100. Plural R¹ and R³ may be the same or different to one another when n or m are 2 or more. t and u each independently represents 0 or 1. Z¹ and Z² each independently represent an alkali metal ion, an alkali earth metal ion, or a non-substituted ammonium ion or an ammonium ion substituted with an alkyl group p and q each independently represents an integer selected from 0 to 2.
The content of the chelating agent is in the range of 15 to 200 mmol/L, and the chelating agent is preferably a hydroxycarboxylic acid.

### EXAMPLES

While the invention is described with reference to examples, the invention is by no means restricted to these examples.

### [Photosensitive planographic printing plate 1]

### [Preparation of support]

### <Aluminum plate>

An aluminum alloy containing 0.06% by mass Si, 0.30% by mass Fe, 0.001% by mass Cu, 0.001% by mass Mn, 0.001% by mass Mg, 0.001% by mass Zn and 0.03% by mass Ti, the balance being A1 and inevitable impurities, was used to prepare a melt, then subjected to a molten metal treatment, filtered and formed into an ingot of 500 mm in thickness and 1200 mm in width with a DC casting method. After its surface layer of 10 mm in average thickness was shaved with a surface shaving machine, the ingot was kept at 550°C for about 5 hours, and when the temperature was reduced to 400°C, the ingot was formed into a rolled plate of 2.7 mm in thickness with a hot rolling mill. Then, the plate was subjected to heat treatment at 500°C with a continuous annealing device and finished in cold rolling to give the plate a thickness of 0.24 mm as an aluminum plate of JIS 1050 material. This aluminum plate was formed into a plate of 1030 mm in width and then subjected to the following surface treatment.

### <Surface treatment>

In the surface treatment, the following treatments (a) to (j) were successively conducted. After each treatment and water washing, all remaining liquid was removed with nip rollers.

### (a) Mechanical roughening

The surface of the aluminum plate was subjected to mechanical surface roughening treatment with a rotating roller-shaped nylon brush while being supplied with an aqueous suspension of an abrasive having a specific gravity of 1.12 (Pamis) as an abrasive slurry. The average particle diameter of the abrasive was 30 µm, and the maximum particle diameter was 100 µm. The nylon brush was made of 6·10 nylon, the length of the brush bristle was 45 mm, and the diameter of the brush bristle was 0.3 mm. The nylon brush had bristles arranged densely in holes in a stainless steel cylinder of φ300 mm. Three rotating brushes were used. The distance between the two supporting rollers (φ200 nm) under the brushes was 300 mm. The brush roller was pressed against the aluminum plate until the loading of a driving motor for rotating the brush was increased to 7 kW plus relative to the loading before the brush roller was pressed against the aluminum plate. The direction of rotation of the brush was the same as the transporting direction of the aluminum plate. The number of revolutions of the brush was 200 rpm.

### (b) Alkali etching treatment

The aluminum plate obtained above was subjected to etching treatment by spraying with an aqueous solution of sodium hydroxide at a concentration of 2.6% by mass and aluminum ion at a concentration of 6.5% by mass at a temperature of 70°C, whereby the aluminum plate was dissolved in an amount of 10 g/m². Thereafter, the aluminum plate was washed by spraying with water.

### (c) Desmut treatment

The aluminum plate was subjected to desmut treatment with an aqueous solution (containing 0.5% by mass aluminum ion) of 1% by mass nitric acid at a temperature of 30°C and then washed by spraying with water. The aqueous solution of nitric acid used in desmut treatment was a waste liquid in the step of electrochemical surface roughening treatment with an alternating current in an aqueous solution of nitric acid.

### (d) Electrochemical surface roughening treatment

The plate was continuously subjected to electrochemical surface roughening treatment with an alternating voltage of 60 Hz. The electrolytic solution used was 10.5 g/L aqueous nitric acid solution (containing 5 g/L aluminum ion and 0.007% by mass ammonium ion) at a temperature of 50°C. The electrochemical surface roughening treatment was carried out with a carbon electrode as a counter electrode, wherein the alternating current power source waveform is of the time TP required for the electric current to reach from 0 to the peak was 0.8 msec., the duty ratio was 1:1 and a trapezoid rectangular wave alternating current was used. Ferrite was used as an auxiliary anode.
The current density was 30 A/dm² in terms of the electric current peak, and the electrical quantity was 220 C/dm² in terms of the total electrical quantity upon anodizing of the aluminum plate. An effective shunt current of 5% of the electric current from the power source was fed to the auxiliary anode. Thereafter, the plate was washed by spraying with water.

### (e) Alkali etching treatment

The aluminum plate was subjected to etching treatment by spraying with an aqueous solution of sodium hydroxide at a concentration of 26% by mass and aluminum ion at a concentration of 6.5% by mass at a temperature of 32°C, whereby the aluminum plate was dissolved in an amount of 0.50 g/m², and smut components based on aluminum hydroxide formed by the electrochemical surface roughening treatment using the alternating current in the previous stage were removed, and the edge of the formed pit was dissolved to smooth the edge. Thereafter, washing by spraying with water was carried out.

### (f) Desmut treatment

The aluminum plate was subjected to desmut treatment with an aqueous solution (containing 4.5% by mass aluminum ion) of 15% by mass nitric acid at a temperature of 30°C and then washed by spraying with water. The aqueous solution of nitric acid used in desmut treatment was waste liquid in the step of electrochemical surface roughening treatment with an alternating current in an aqueous solution of nitric acid.

### (g) Electrochemical surface roughening treatment

The plate was subjected continuously to electrochemical surface roughening treatment with an alternating voltage of 60 Hz. The electrolyte used was 5.0 g/L aqueous hydrochloric acid solution (containing 5 g/L aluminum ion) at a temperature of 35°C. The electrochemical surface roughening treatment was carried out with a carbon electrode as a counter electrode, wherein alternating current power source waveform is of the time TP required for the electric current to reach from 0 to the peak was 0.8 msec., the duty ratio was 1:1 and a trapezoid rectangular wave alternating current was used. Ferrite was used as an auxiliary anode.
The current density was 25 A/dm² in terms of the electric current peak, and the electrical quantity was 50 C/dm² in terms of the total electrical quantity upon anodizing of the aluminum plate. Thereafter, the plate was washed by spraying with water.

### (h) Alkali etching treatment

The aluminum plate was subjected to etching treatment by spraying with an aqueous solution of sodium hydroxide at a concentration of 26% by mass and aluminum ion at a concentration of 6.5% by mass at a temperature of 32°C, whereby the aluminum plate was dissolved in an amount of 0.10 g/m², and smut components based on aluminum hydroxide formed by the electrochemical surface roughening treatment using the alternating current in the previous stage were removed, and the edge of the formed pit was dissolved to smooth the edge. Thereafter, washing by spraying with water was carried out.

### (i) Desmut treatment

The aluminum plate was subjected to desmut treatment with an aqueous solution (containing 0.5% by mass aluminum ion) of 25% by mass sulfuric acid at a temperature of 60°C and then washed by spraying with water.

(j) Anodizing treatment Anodizing treatment was carried out with an anodizing device to provide a support for planographic printing. The electrolytic solution supplied to the first and second electrolytic zones were sulfuric acid solution. Both the electrolytes were 170 g/L sulfuric acid (containing 0.5% by mass aluminum ion) at a temperature of 38°C. Thereafter, washing by spraying with water was carried out. The final anodized coating was 2.7 g/m². The Ra of the substrate obtained by the above treatment was 0.45.

### [Undercoat]

Next, an undercoat solution shown below was applied by use of a wire bar onto the aluminum support and dried at 90°C for 30 seconds in a hot-air drying oven. The amount of the coating after drying was 10 mg/m².

### <Undercoat solution>

| | |
|---|---|
| ·Ethyl acrylate/sodium 2-acrylamide-2-methyl-1-propanesulfonate copolymer (molar ratio 75:15) | 0.1 g |
| .Methanol | 50 g |
| ·Deionized water | 50 g |

### [Photosensitive layer]

Next, the photosensitive layer coating solution [P-1] below was prepared and applied by the use of a wire bar onto the aluminum support which had been coated with the undercoat described above. The solution was dried at 122°C for 43.5 seconds in a hot-air drying oven to form a photosensitive layer. The coating amount after drying was 1.4 g/m².

### <Coating solution for photosensitive layer (P-1)>

| | |
|---|---|
| ·Infrared absorber (IR-1) | 0.08 g |
| ·Polymerization initiator (OS-1) | 0.25 g |
| ·Dipentaerythritol hexaacrylate | 1.00 g |
| ·Binder polymer (BT-1) | 1.00 g |
| ·Ethyl Violet chloride salt | 0.04 g |
| ·Fluorine-type surfactant | 0.03 g |
| (MEGAFAC F-780-F, manufactured by Dainippon Ink and Chemicals, Inc.) ·Methyl ethyl ketone | 10.4 g |
| ·Methanol | 4.83 g |
| ·1-Methoxy-2-propanol | 10.4 g |

The structures of the infrared absorber (IR-1), the polymerization initiator (OS-1) and the binder polymer (BT-1) used in the photosensitive layer coating solution are shown below:

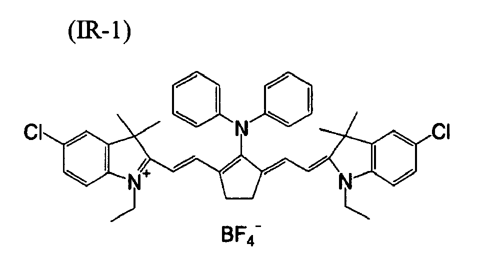

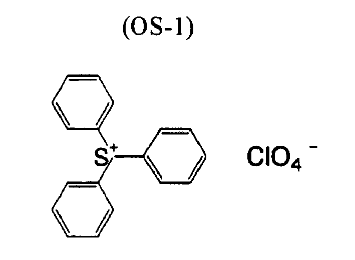

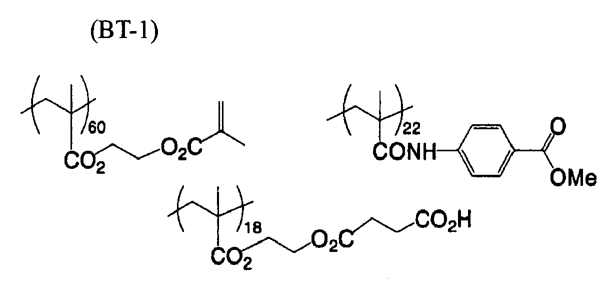

### [Protective layer (overcoat layer)]

The coating solution (OC-1) for the protective layer described below was coated on the surface of the photosensitive layer using a wire bar. The layer was dried at 125°C for 75 seconds with a hot air dryer to form the protective layer, and photosensitive planographic printing plate 1 was obtained. The content of PVA in the protective layer was 85% by mass, and the coating amount (the amount of the coating film after drying) was 2.45 g/m².

### [Coating solution (OC-1) for the protective layer]

An aqueous mixed solution of polyvinyl alcohol (saponification value: 98 mol%, degree of polymerization: 500) and polyvinyl pyrrolidone (trade name; Rubiscol K-30 manufactured by BASF Co., Ltd.)

Then, the coating solution for the protective layer (OC-2) shown below was coated on the photosensitive layer (P-1), which was formed by coating the coating solution for the photosensitive layer on the support after undercoating, as same in photosensitive planographic printing plate 1, and photosensitive planographic printing plate 2 was obtained.

### [Coating solution (OC-2) for the protective layer]

A mixed aqueous solution of a synthetic mica (trade name: Somashiff ME-100, 8% aqueous dispersion solution, manufactured by COOP CHEMICAL Co., Ltd.), terminal acid-modified polyvinyl alcohol (trade name: JM-O5, saponification value: 94 mol%, degree of polymerization: 500, manufactured by JAPAN VAN & POVAL Co., Ltd), copolymer of polyvinyl pyrrolidone and vinyl acetate (trade name: LUVITEC VA64W, polyvinyl pyrrolidone/vinyl acetate = 6/4, manufactured by ICP Co., Ltd.) and surfactant (trade name: Emulex 710, manufactured by NIPPON EMULSION Co., Ltd.).

The coating solution (OC-2) for the protective layer was coated on the plate with a wire bar, and the layer was dried at 125°C for 75 seconds using a hot air dryer.

The solid content of mica/polyvinyl alcohol/copolymer of polyvinyl pyrrolidone and vinyl acetate/surfactant ratio was 16/80/2/2 (% by mass), and the total coating amount (coating amount after drying) was 1.3 g/m².

Photosensitive planographic printing plate 2 was thus obtained.

### [Preparation of developer]

### <Developer-1>

Developer-1 with a pH of 12.0 was prepared by dissolving the following components in water.

| | |
|---|---|
| · Specific surfactant (K-1) | 5.27% by mass |
| · 2,4,7,9-tetramethyl-5-decin-4,7-diol (antifoam agent) | 0.001% by mass |
| · Sodium ethylenediamine tetraacetate | 0.21% by mass |
| · Potassium carbonate | 0.21% by mass |
| · KOH | 0.103% by mass |

### <Developer-2>

Developer-2 with a PH of 11.1 was prepared by dissolving the following components in water.

| | |
|---|---|
| · Specific surfactant (K-1) | 5.26% by mass |
| · 2,4,7,9-tetramethyl-5-decin-4,7-diol (antifoam agent) | 0.001% by mass |
| · Sodium ethylenediamine tetraacetate | 0.17% by mass |
| · Potassium carbonate | 1.55% by mass |
| · KOH | 0.11% by mass |

### <Replenisher-A>

Replenisher-A with a PH of 13.0 was prepared by dissolving the following components in water.

| | |
|---|---|
| · Specific surfactant (K-1) | 4.11% by mass |
| · Potassium citrate (specific chelating agent) | 0.975% by mass |
| · 2,4,7,9-tetramethyl-5-decin-4,7-diol (antifoam agent) | 0.001% by mass |
| · Sodium ethylenediamine tetraacetate | 0.16% by mass |
| · KOH | 1.39% by mass |

### <Replenisher-B to F>

Replenisher-B was prepared by preparing the same replenisher as replenisher A, except that sodium citrate was used in the same % by mass in place of tripotassium citrate as the specific chelating solution used in replenisher-A.
Replenisher-C was prepared by adding the same amount of potassium malate as the specific chelating agent, replenisher-D was prepared by using sodium hydrogen malate, replenisher-E was prepared by using potassium tartarate, and replenisher-F was prepared by using potassium malonate.

### <Replenisher-G>

A replenisher having the quite same components as replenisher-A was used as replenisher-G, except that the surfactant in replenisher-A was replaced from specific surfactant (K-1) to specific surfactant (K-3).

### <Replenisher-H>

Replenisher-H with a PH of 12.8 was prepared by dissolving the following components in water.

| | |
|---|---|
| · Specific surfactant (K-1) | 4.80% by mass |
| · Tripotassium citrate | 0.975% by mass |
| · 2,4,7,9-tetramethyl-5-decin-4,7-diol (antifoam agent) | |
| | 0.001% by mass |
| · Sodium ethylenediamine tetraacetate | 0.17% by mass |
| · Potassium carbonate | 1.55% by mass |
| · KOH | 1.30% by mass |

### <Replenisher-I to K>

A replenisher-I having quite the same components as replenisher-H was prepared as replenisher-I, except that sodium citrate was added in the same % by mass in place of tripotassium citrate as a specific chelating agent in replenisher-H.
Replenisher-J was prepared by adding the same amount of potassium malate as the specific chelating agent, and replenisher-K was prepared by using sodium malate.

### <Comparative replenisher-X>

Comparative replenisher-X was prepared by obtaining a replenisher comprising the same components as replenisher-A and by adjusting the pH to 13.0, except that the specific surfactant in replenisher-A was omitted.

### <Comparative replenisher-Y>

Comparative replenisher-Y was prepared by obtaining a replenisher comprising the same components as replenisher-A, except that potassium citrate as the specific surfactant in replenisher-A was omitted.

### (Evaluation of plate making property, development property, and dirty printing)

The resultant planographic printing plate precursors 1 and 2 were exposed to light with output power in the range of 0 to 8 W changed by increments of 0.15 in log E with a resolution of 175 lines per inch (lpi) at an outer drum revolution number of 150 rpm using a Trendsetter-3244VX (from CREO Co., Ltd.) equipped with a water-cooled 40-W infrared semiconductor laser. Exposure was carried out at 25°C and 50% RH.
After the exposure, the above two kinds of the developers were poured into an automatic development machine for newspaper thermal printing plates LP-1310 NEWS (trade name; manufactured by FUJI PHOTOFILM Co., Ltd.), and the replenisher was poured into the replenisher tank. The printing plates were developed at 30°C for 12 seconds while automatically replenishing at 40 mL per m² of the printing plate material with the replenisher. Tap water filled into an 18 L rinsing tank was sprayed onto the printing plates for rinsing, while circulating the water with a pump. Fresh water, at 80 mL per m² of the printing plate material was replenished during the rinsing step. A 1:1 aqueous dilution solution of FP-2W (trade name, manufactured by FUJI PHOTOFILM Co., Ltd.) was used as a finisher.
The developer was used for developing 2,000 m² of printing plate for evaluating contamination with aluminum hydroxide as will be described below, and the planographic printing plate for evaluation of soiling properties of non-image portions was developed after almost 100% of the developer used above had been replaced with the replenisher.

### [Evaluation of dirty printing]

The planographic printing plates obtained were used for printing with a printing machine (trade name Lithron, manufactured by KOMORI CORPORATION) using a red ink (trade name GEOS; manufactured by DAINIPPON INK & CHEMICALS, Inc.) to visually evaluate soiling properties of non-image portions. Those plates showing no soiling, and those showing soiling were evaluated as A and B, respectively.

### (Evaluation of development property)

After the developer was used for development of 2000 m² of printing plate material by using the automatic development machine for newspaper thermal printing plates LP-1310 NEWS (trade name; manufactured by FUJI PHOTOFILM Co., Ltd.), the same as in the evaluation method of dirty printing, evaluation was made after almost 100% of the developer had been replaced with replenishing solution. After developing the printing plate at 30°C for 12 seconds, the printing plate was evaluated by observing the development properties of the non-image portions. Development properties were evaluated as A when no residual film was observed and as B when residual film was observed.

### (Evaluation of soiling by precipitation of aluminum hydroxide)

The planographic printing plate 1 was developed under the conditions of daily operation of 16 hours using the same automated developing machine LP-1310 NEWS under the same conditions as the above development 3000 m² of plate making was carried out, using an amount of replenishment of the used developer of 70 mL/m², and an amount of replenishment of rinsing water of 80 mL/m² with a development rate of 100 m²/day. After 30 days' operation, soiling by adhesion of aluminum hydroxide onto a squeeze roller at the exit of the development bath and the amount of aluminum hydroxide precipitated in the rinsing bath were measured.
Roller soiling was evaluated as A (no adhesion) or B (adhesion).
Precipitation was evaluated as A (no precipitation), B (small amount of precipitation) and C (considerable precipitation). BC represents an intermediate amount of precipitation between B and C.
The results of evaluation are shown in Table 1 below.

**[TABLE 1]**

| | Photosensitive Planografic Printing Plate | Developer No. /Replenisher Type | Spec. Chelate Comp. in Replenisher | Surfactant | Development Property | Dirty Printing of Non-Image Portion | Developer Bath Roller Soiling | Precipitation in Rinse Bath |
|---|---|---|---|---|---|---|---|---|
| EXAMPLE 1 | Planografic Print. Plate 1 | Developer-1 /Replenisher-A | Potassium Citrate | K-1 | A | A | A | A |
| EXAMPLE 2 | Planografic Print. Plate 1 | Developer-1 /Replenisher-B | Sodium Citrate | K-1 | A | A | A | A |
| EXAMPLE 3 | Planografic Print. Plate 1 | Developer-1 /Replenisher-C | Potassium Malate | K-1 | A | A | A | A |
| EXAMPLE 4 | Planografic Print. Plate 1 | Developer-1 /Replenisher-D | Sodium Hydrogen Malate | K-1 | A | A | A | A |
| EXAMPLE 5 | Planografic Print. Plate 1 | Developer-1 /Replenisher-E | Potassium Tartarate | K-1 | A | A | A | A |
| EXAMPLE 6 | Planografic Print. Plate 1 | Developer-1 /Replenisher-F | Potassium Malonate | K-1 | A | A | A | A |
| EXAMPLE 7 | Planografic Print. Plate 1 | Developer-1 /Replenisher-G | Potassium Citrate | K-3 | A | A | A | A |
| EXAMPLE 8 | Planografic Print. Plate 1 | Developer-2 /Replenisher-H | Potassium Citrate | K-1 | A | A | A | A |
| EXAMPLE 9 | Planografic Print. Plate 1 | Developer-2 /Replenisher-I | Sodium Citrate | K-1 | A | A | A | A |
| EXAMPLE 10 | Planografic Print. Plate 1 | Developer-2 /Replenisher-J | Potassium Malate | K-1 | A | A | A | A |
| EXAMPLE 11 | Planografic Print. Plate 1 | Developer-2 /Replenisher-K | Sodium Hydrogen Malate | K-1 | A | A | A | A |
| EXAMPLE 12 | Planographic Print. Plate 2 | Developer-1 /Replenisher-A | Potassium Citrate | K-1 | A | A | A | A |
| EXAMPLE 13 | Planografic Print. Plate 2 | Developer-1 /Replenisher-D | Sodium Hydrogen Malate | K-1 | A | A | A | A |
| EXAMPLE 14 | Planografic Print. Plate 2 | Developer-1 /Replenisher-E | Potassium Tartarate | K-1 | A | A | A | A |
| EXAMPLE 15 | Planografic Print. Plate 2 | Developer-1 /Replenisher-F | Potassium Malonate | K-1 | A | A | A | A |
| EXAMPLE 16 | Planografic Print. Plate 2 | Developer-1 /Replenisher-G | Potassium Citrate | K-3 | A | A | A | A |
| COMPARATI VE EXAMPLE 1 | Planografic Print. Plate 1 | Developer-1 /Replenisher-X | Potassium Citrate | None | B | B | A | A |
| COMPARATI VE EXAMPLE 2 | Planografic Print. Plate 1 | Developer-1 /Replenisher-Y | No Chelating Agent | K-1 | A | A | B | C |
| COMPARATI VE EXAMPLE 3 | Planografic Print. Plate 2 | Developer-1 /Replenisher-X | Potassium Citrate | None | B | B | A | A |
| COMPARATI VE EXAMPLE 4 | Planografic Print. Plate 2 | Developer-1 /Replenisher-Y | No Chelating Agent | K-1 | A | A | B | C |

Table 1 shows that good development property is obtained by developing the planographic printing table using the replenisher of the invention even when a non-silicate type alkaline developer having a low pH that causes little damage to the recording layer is used. Moreover, adhesion soiling of the development bath roller and precipitation of aluminum hydroxide in the rinsing bath can be effectively suppressed.
The replenisher used in the invention is suitable for a planographic printing plate precursor comprising a negative working recording layer on an aluminum support having a hydrophilic surface, and contains no silicate compounds and has a pH of 10.5 to 12.5. Good development property is obtained by using this replenisher and rinsing with water thereafter in the rinsing bath. Precipitation of aluminum hydroxide is effectively suppressed in the development and rinsing steps and, as a result, soiling adhesions mainly comprising aluminum hydroxide on the surface of the development bath roller, and accumulation of precipitates of aluminum hydroxide are reduced. Therefore, the invention provides a replenisher capable of developing stably for a long period of time.
The invention also provides a plate making method of the precursor of the negative type photosensitive planographic plate, wherein the method is able to remarkably reduce the amount of precipitates of aluminum hydroxide accumulated on the surface of the development bath roller and in the rinsing bath. According to the method of the invention, development property of the precursor of the planographic printing plate having a recording layer using a negative working photosensitive composition is excellent, even using an alkaline developer having a low pH.
According to the replenisher for the negative working photosensitive planographic plate of the invention, good development property is obtained without reducing printing durability by ensuring sufficient development property even by using a low pH alkaline developer that causes little damage to the recording layer component constituting the image portion. In addition, soiling, mainly comprising aluminum hydroxide, is suppressed from remaining in the development bath and on the development roller under long-term continuous development.
According to the plate making method of the photosensitive planographic printing plate using the replenisher of the invention, the amount of precipitate of aluminum hydroxide accumulated on the surface of the developer bath roller and in the rinsing bath, and the development property of the planographic printing plate precursor having a recording layer using a negative working photosensitive composition is excellent, even using an alkaline developer with a low pH.

## Claims

1. A replenisher for a negative working photosensitive planographic plate that does not contain silicate compounds comprising: a chelating agent, having an ability to form a water-soluble chelate compound with aluminum ions; an alkali metal hydroxide; and, a surfactant; and being an aqueous solution with a pH of 11 to 13.5.

2. A replenisher for a negative working photosensitive planographic plate used in development processing for plate making the processing including (i) image-wise exposing a precursor of a planographic printing plate including a negative working recording layer on an aluminum support, and (ii) developing the exposed image using a developer containing no silicate compounds, the developer including an alkali metal hydroxide and a surfactant and having a pH of 10.5 to 12.5, and the replenisher, wherein
the replenisher does not contain silicate compounds and is an aqueous solution comprising: a chelating agent, having the ability to form a water-soluble chelate compound with aluminum ions; an alkali metal hydroxide; and, a surfactant; and has a pH of 11 to 13.5.

3. The replenisher for a negative working photosensitive planographic plate according to Claim 2, wherein the negative working recording layer comprises a compound for generating radicals by light or heat, a polymerizable compound and a radiation absorbing agent.

4. The replenisher for a negative working photosensitive planographic plate according to any one of Claims 1 to 3, wherein the surfactant is at least one selected from the group consisting of the compounds represented by following formulae (1-A) and (1-B), and the content of the surfactant is in the range of 1.0% by mass to 10% by mass: 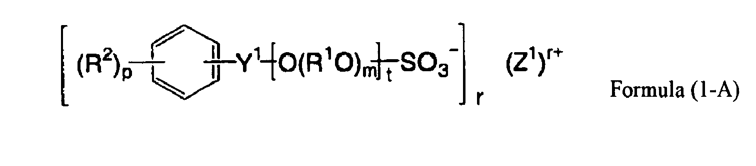 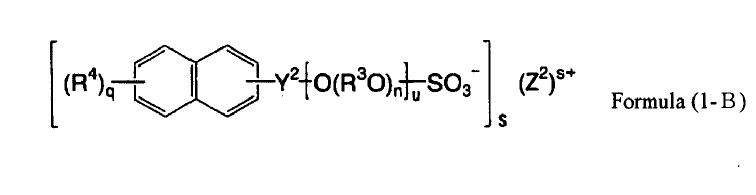 wherein, in the formulae (1-A) and (1-B), R¹ and R³ each independently represents a linear or branched alkylene group having 1 to 5 carbon atoms; R² and R⁴ each independently represents a liner or branched alkyl group having 1 to 20 carbon atoms; r and s each independently represents 0, 1 or 2; Y¹ and Y² each independently represents a single bond or an alkylene group having 1 to 10 carbon atoms; n and m each independently represents an integer of 1 to 100; and when n or m are 2 or more, plural R¹ and R³ may be the same or different from each other; t and u each independently represents 0 or 1; Z¹ and Z² each independently represents an alkali metal ion, an alkali earth ion, or a non-substituted ammonium ion or an ammonium ion substituted with an alkyl group; and p and q each independently represents an integer selected from 0 to 2.

5. The replenisher for a negative working photosensitive planographic plate according to any one of Claims 1 to 4, wherein the content of the chelating agent is from 15 to 200 mmol/L.

6. The replenisher for a negative working photosensitive planographic plate according to any one of Claims 1 to 5, wherein the chelating agent is a hydroxycarboxylic acid.

7. A plate making method of a photosensitive planographic printing plate comprising (i) exposing a precursor of a photosensitive planographic printing plate including a negative working recording layer on an aluminum support having a hydrophilic surface, (ii) developing the precursor of the planographic printing plate after exposure using a developer containing no silicate compounds, the developer including an alkali metal hydroxide and a surfactant and having a pH of 10.5 to 12.5, and a replenisher, and (iii) rinsing the planographic printing plate after development with water, wherein
the replenisher used in the developing (ii) does not contain silicate compounds and is an aqueous solution containing: a chelating agent, having the ability to form a water-soluble chelate compound with aluminum ions; an alkali metal hydroxide; and a surfactant; and has a pH of 11 to 13.5.

8. The plate making method of a photosensitive printing plate according to Claim 7, wherein the negative working recording layer comprises a compound for generating radicals by light or heat, a polymerizable compound, and a radiation absorbing agent.

9. The plate making method of a photosensitive printing plate according to any one of Claims 7 and 8, wherein the surfactant is at least one selected from the group consisting of the compounds represented by following formulae (1-A) and (1-B), and the content of the surfactant is in the range of 1.0% by mass to 10% by mass: 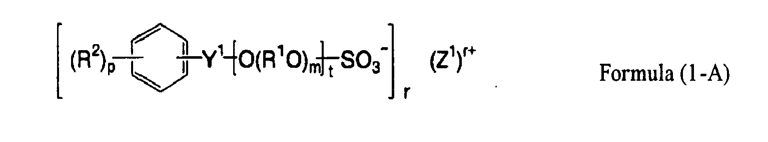 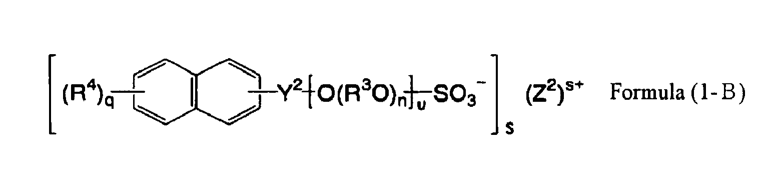 wherein, in the formulae (1-A) and (1-B), R¹ and R³ each independently represents a linear or branched alkylene group having 1 to 5 carbon atoms; R² and R⁴ each independently represents a liner or branched alkyl group having 1 to 20 carbon atoms; r and s each independently represents 0, 1 or 2; Y¹ and Y² each independently represents a single bond or an alkylene group having 1 to 10 carbon atoms; n and m each independently represents an integer of 1 to 100; and when n or m are 2 or more, plural of R¹ and R³ may be the same or different from each other; t and u each independently represents 0 or 1; Z¹ and Z² each independently represents an alkali metal ion, an alkali earth ion, or a non-substituted ammonium ion or an ammonium ion substituted with an alkyl group; and p and q each independently represents an integer selected from 0 to 2.

10. The plate making method of a photosensitive planographic printing plate according to any one of Claims 7 to 9, wherein the content of the chelating agent is from 15 to 200 mmol/L.

11. The plate making method of a photosensitive planographic printing plate according to any one of Claims 7 to 10, wherein the chelating agent is a hydroxycarboxylic acid.
